# EUROPEAN PATENT SPECIFICATION

(11) **EP 2 508 527 B1**
(45) Date of publication and mention of the grant of the patent: **07.01.2015**
(21) Application number: 10833300.6
(22) Date of filing: 26.11.2010
(51) Int. Cl.: C07F 15/00, C09K 11/06, H01L 51/50, H05B 33/14, H01L 51/00

(54) **IRIDIUM COMPLEX COMPOUND, ORGANIC ELECTROLUMINESCENCE ELEMENT, AND USES THEREOF**
IRIDIUMKOMPLEXVERBINDUNG, ORGANISCHES ELEKTROLUMINESZENZELEMENT UND VERWENDUNGEN DAVON
COMPOSÉ COMPLEXE D'IRIDIUM, ÉLÉMENT ÉLECTROLUMINESCENT ORGANIQUE ET SON UTILISATIONS

(30) Priority: 30.11.2009 JP 2009272909
(43) Date of publication of application: 10.10.2012
(73) Proprietor: Samsung Electronics Co., Ltd., Suwon-si, Gyeonggi-do 443-772 (KR)
(72) Inventor: TERASHIMA, Takashi, Chiba-shi Chiba 267-0056 (JP); TAGUCHI, Isamu, Chiba-shi Chiba 267-0056 (JP); TAJIMA, Masaru, Chiba-shi Chiba 267-0056 (JP); TAKAHASHI, Yoshiaki, Chiba-shi Chiba 267-0056 (JP)
(74) Representative: Greene, Simon Kenneth
(86) International application number: PCT/JP2010/071077
(87) International publication number: WO 2011/065454

(56) References cited:
- JP-A- 2006 151 888
- JP-A- 2009 023 938
- JP-A- 2009 132 688
- JP-A- 2009 185 017
- US-A1- 2008 269 491
- DATABASE CA [Online] CHEMICAL ABSTRACTS SERVICE, COLUMBUS, OHIO, US; 2008, JABBOUR, GHASSAN E. ET AL: "Organometallic materials for optical emission, optical absorption, and devices including organometallic materials", XP002693773, retrieved from STN Database accession no. 2008:1310454 & US 2008/269491 A1 (JABBOUR, GHASSAN E. ET AL) 30 October 2008 (2008-10-30)
- PARK ET AL: "Heteroleptic tris-cyclometalated iridium(III) complexes with phenylpridine and diphenylquinoline derivative ligands", THIN SOLID FILMS, ELSEVIER-SEQUOIA S.A. LAUSANNE, CH, vol. 515, no. 12, 23 April 2007 (2007-04-23), pages 5084-5089, XP022212188, ISSN: 0040-6090, DOI: 10.1016/J.TSF.2006.10.019
- DATABASE CA [Online] CHEMICAL ABSTRACTS SERVICE, COLUMBUS, OHIO, US; 2007, PARK, GUI YOUN ET AL: "Iridium complexes containing three different ligands as white OLED dopants", XP002693774, retrieved from STN Database accession no. 2007:232601 & PARK, GUI YOUN ET AL: "Iridium complexes containing three different ligands as white OLED dopants", MOLECULAR CRYSTALS AND LIQUID CRYSTALS , 462, 179-188 CODEN: MCLCD8; ISSN: 1542-1406, 2007,
- PARK GUI YOUN ET AL: "Iridium complexes containing three different ligands as white OLED dopants", MOLECULAR CRYSTALS AND LIQUID CRYSTALS, TAYLOR & FRANCIS, UK, vol. 462, 1 January 2007 (2007-01-01), pages 179-188, XP008160706, ISSN: 1542-1406, DOI: 10.1080/07370650601013120

## Description

### Technical Field

The present invention relates to an iridium complex compound, an organic electroluminescent element and uses thereof.

### Background Art

Phosphorescent compounds have high luminous efficiency, and therefore, studies and development of them as luminescent materials in organic electroluminescent elements (also referred to as "organic EL elements" in this specification) have been energetically carried out in recent years.

Organic EL elements using phosphorescent compounds have been expected to be extensively applied to various uses, and in JP-A-2003-526876 (patent literature 1), it is disclosed that use of an organoiridium complex as a phosphorescent compound can greatly enhance luminous efficiency of an organic EL element. As examples of the iridium complex compounds, tris (2- (2-pyridyl) phenyl) iridium and its derivatives are given, and it is described that by changing a substituent of a ligand of an aromatic structure to an alkyl group or an aryl group, the color of emitted light of the iridium complex compound varies. In JP-A-2001-247859 (patent literature 2), various groups are given as examples of substituents of tris(2-(2-pyridyl)phenyl)iridium.

In non patent literatures 1, 2 and 3, red phosphorescent materials having organic electroluminescence properties have been reported. These pigments, however, have low emission quantum yields, and organic EL elements produced by using these pigments have a problem of low luminous efficiency.

### Citation List

### Patent Literature

Patent literature 1: JP-A-2003-526876
Patent literature 2: JP-A-2001-247859

### Non Patent Literature

Non patent literature 1: J. Am. Chem. Soc., 2003, 125, 12971-12979
Non patent literature 2: Dalton Trans., 2005, 1538-1590
Non patent literature 3: Inorg. Chem., 2005, 44, 5677-5685 Mol. Cryst. Liq. Cryst., Vol. 462, pp. 179-188, 2007, discloses i.a. compounds Ir(ppy)₂(piq-F) and Ir(piq-F)₂(F₂-ppy).

THIN SOLID FILMS, vol. 515, pp. 5084-5089, 2007 discloses heteroleptic tris-cyclometalated iridium(III) complexes with phenylpridine and diphenylquinoline derivative ligands.

### Summary of Invention

### Technical Problem

The present invention has been made in view of such problems, and it is an object of the present invention to provide a red phosphorescent compound which has a high emission quantum yield and exhibits high luminous efficiency when it is used for producing an organic EL element.

It is known that there is a high correlation between the emission quantum yield of a luminescent compound and the luminous efficiency of an organic EL element produced using the compound. Therefore, by developing a red phosphorescent compound having a high emission quantum yield, a red organic EL element having high luminous efficiency is obtained.

In order to solve the above problem, the present inventors have earnestly studied, and as a result, they have found that iridium complexes, which are hetero type iridium complexes constituted of different ligands and use a combination of a first ligand that is a ligand used for red phosphorescent compounds such as phenylquinoline and phenylisoquinoline and a second ligand that is a phenylpyridyl ligand wherein an electron attractive substituent has been introduced into a phenyl group, have high emission quantum yields, and organic EL elements containing them in their luminescent layers have high emission efficiency.

The reason is that a ligand having a high transition dipole moment tends to increase an emission quantum yield of an iridium complex, so that by the use of a ligand wherein an electron attractive substituent has been introduced, the emission quantum yield is increased, and by combining a ligand exhibiting red luminescence with it, a red phosphorescent material having a high emission quantum yield is obtained.

In JP-A-2006-513278, etc., red luminescent iridium complexes using a combination of plural ligands have been synthesized so far, but their emission quantumyields are insufficient.

It is an object of the present invention is to show molecular design of a red phosphorescent compound which has a higher emission quantum yield and exhibits higher luminous efficiency in the production of an organic EL element as compared with conventional red phosphorescent materials and to provide an iridium complex compound.

### Solution to Problem

In order to solve the above problem, the present inventors have earnestly studied. As a result, they have found that red phosphorescent compounds having a specific structure exhibit high emission quantum yields and organic EL elements containing them in their luminescent layers have high luminous efficiency. Thus, the present inventors have accomplished the present invention.

That is to say, the present invention is summarized as below.

### [1]

An iridium complex compound represented by the following formula (1) :

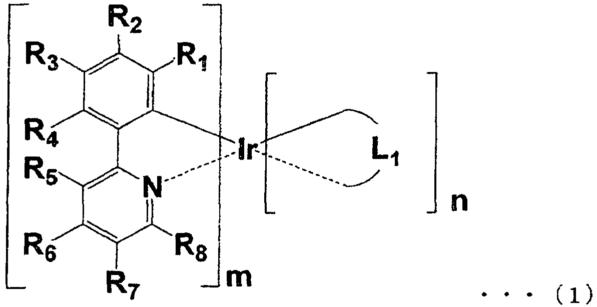

wherein R₁ to R₄ are each independently a hydrogen atom, a fluorine atom, a cyano group, an alkyl group of 1 to 10 carbon atoms, or an alkyl group of 1 to 10 carbon atoms in which at least one hydrogen atom has been replaced with a fluorine atom, at least one of R₁ to R₄ is any one of a fluorine atom, a cyano group and an alkyl group of 1 to 10 carbon atoms in which at least one hydrogen atom has been replaced with a fluorine atom, R₅ to R₈ are each independently a hydrogen atom, an alkyl group of 1 to 30 carbon atoms, an aryl group of 6 to 40 carbon atoms, an aralkyl group of 7 to 40 carbon atoms, an amino group which may be substituted with an alkyl group of 1 to 30 carbon atoms, an alkoxy group of 1 to 30 carbon atoms, or a silyl group which may be substituted with an alkyl group of 1 to 30 carbon atoms, adjacent R groups of R₁ to R₈ do not undergo mutual bonding for forming a ring, L₁ is formula (3), m is 1 or 2, n is 1 or 2, and m+n is 3,

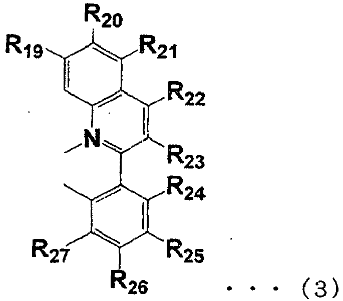

wherein R₁₉ to R₂₇ are each independently a hydrogen atom, a cyano group, a nitro group, a halogen atom, an alkyl group of 1 to 30 carbon atoms which may have a substituent, an alkylamino group of 1 to 30 carbon atoms which may have a substituent, an arylamino group of 6 to 30 carbon atoms which may have a substituent, an alkoxy group of 1 to 30 carbon atoms which may have a substituent, a halogenated alkoxy group of 1 to 30 carbon atoms which may have a substituent, an aromatic oxy group of 6 to 30 carbon atoms whichmayhave a substituent, an aryl group of 6 to 40 carbon atoms which may have a substituent, a heterocyclic group of 3 to 30 carbon atoms whichmayhave a substituent, a halogenated alkyl group of 1 to 32 carbon atoms which may have a substituent, an alkenyl group of 2 to 30 carbon atoms which may have a substituent, an alkynyl group of 2 to 30 carbon atoms which may have a substituent, a cycloalkyl group of 3 to 30 carbon atoms which may have a substituent, an electron attractive substituent (aldehyde group, acyl group of 2 to 10 carbon atoms, alkoxycarbonyl group of 2 to 10 carbon atoms, aminocarbonyl group of 1 to 10 carbon atoms, thiocyanate group or sulfonyl group of 1 to 10 carbon atoms), an aralkyl group of 7 to 40 carbon atoms, a silyl group which may be substituted with an alkyl group of 1 to 30 carbon atoms, or a group wherein at least one hydrogen atom in these groups has been replaced with a fluorine atom, and at least one of R₂₀ and R₂₂ is an aryl group which may have a substituent.

### [2]

The iridium complex compound as stated in [1], wherein at least two of substituents indicated by R₁ to R₄ in the iridium complex compound represented by the formula (1) are each independently selected from a fluorine atom, a cyano group and an alkyl group of 1 to 10 carbon atoms in which at least one hydrogen atom has been replaced with a fluorine atom.

### [3]

The iridium complex compound as stated in [1] or [2], which has a maximum emission wavelength in the range of 580 to 640 nm.

### [4]

A composition comprising the iridium complex compound as stated in any one of [1] to [3] and a blue luminescent compound having a maximum emission wavelength in the wavelength range of 450 to 490 nm.

### [5]

The composition as stated in [4], wherein the blue luminescent compound is an iridium complex compound represented by the following formula (4), and the iridium complex compound represented by the following formula (4) is contained in an amount of 1 to 100 parts by weight based on 1 part by weight of the iridium complex compound as stated in any one of [1] to [3],

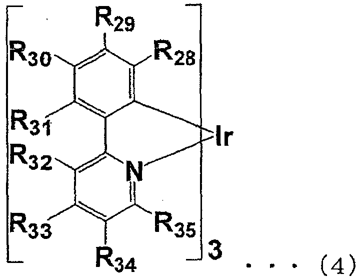

wherein R₃₂ to R₃₅ are each independently a hydrogen atom, an alkyl group of 1 to 30 carbon atoms, an aryl group of 6 to 40 carbon atoms, an aralkyl group of 7 to 40 carbon atoms, an amino group which may be substituted with an alkyl group of 1 to 30 carbon atoms, an alkoxy group of 1 to 30 carbon atoms, a silyl group which may be substituted with an alkyl group of 1 to 30 carbon atoms, a halogen atom or a cyano group, at least one of R₃₂ to R₃₅ is a group of two or more carbon atoms, R₂₈ to R₃₁ are each independently an electron attractive substituent selected from a halogen atom, an alkyl group of 1 to 10 carbon atoms in which at least one hydrogen atom has been replaced with a fluorine atom, an alkoxy group of 1 to 10 carbon atoms in which at least one hydrogen atom has been replaced with a fluorine atom, a cyano group, an aldehyde group, an acyl group of 2 to 10 carbon atoms, an alkoxycarbonyl group of 2 to 10 carbon atoms, an aminocarbonyl group of 1 to 10 carbon atoms, a thiocyanate group and a sulfonyl group of 1 to 10 carbon atoms, an organic group of 1 to 10 carbon atoms which may have a hetero atom (other than the above-mentioned electron attractive substituent) or a hydrogen atom, and at least one of R₂₈ to R₃₁ is the above-mentioned electron attractive substituent.

### [6]

An organic electroluminescent element having a pair of electrodes and one or plural organic layers including a luminescent layer, wherein the luminescent layer contains the iridium complex compound as stated in any one of [1] to [3] or the composition as stated in [4] or [5].

### [7]

The organic electroluminescent element as stated in [6], wherein the luminescent layer further contains a charge transport non-conjugated polymer.

### [8]

An image display device using the organic electroluminescent element as stated in [6] or [7].

### [9]

A surface-emitting light source using the organic electroluminescent element as stated in [6] or [7].

### Advantageous Effects of Invention

The iridium complex compound of the present invention has a high emission quantum yield, and the organic EL element produced by the use of this compound has high luminance and high efficiency.

### Brief Description of Drawing

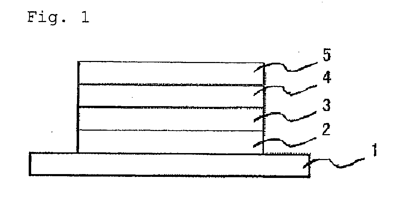

Fig. 1 is a sectional view of an example of the organic EL element of the present invention.

### Description of Embodiments

Next, the present invention is described in detail.

### Iridium complex compound

The iridium complex compound of the present invention is represented by the following formula (1).

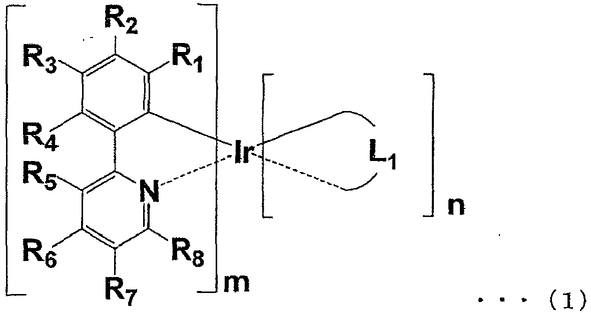

In the formula (1), R₁ to R₄ are each independently a hydrogen atom, a fluorine atom, a cyano group, an alkyl group of 1 to 10 carbon atoms, or an alkyl group of 1 to 10 carbon atoms in which at least one hydrogen atom has been replaced with a fluorine atom, at least one of R₁ to R₄ is any one of a fluorine atom, a cyano group and an alkyl group of 1 to 10 carbon atoms in which at least one hydrogen atom has been replaced with a fluorine atom, R₅ to R₈ are each independently a hydrogen atom, an alkyl group of 1 to 30 carbon atoms, an aryl group of 6 to 40 carbon atoms, an aralkyl group of 7 to 40 carbon atoms, an amino group which may be substituted with an alkyl group of 1 to 30 carbon atoms, an alkoxy group of 1 to 30 carbon atoms, or a silyl group which may be substituted with an alkyl group of 1 to 30 carbon atoms, adjacent R groups of R₁ to R₈ do not undergo mutual bonding for forming a ring, L₁ the following formula (3), m is 1 or 2, n is 1 or 2, and m+n is 3,

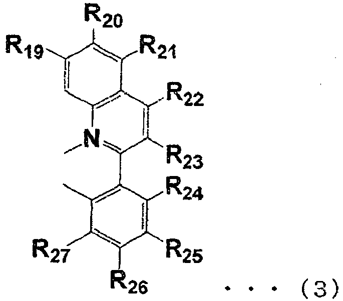

wherein R₁₉ to R₂₇ are each independently a hydrogen atom, a cyano group, a nitro group, a halogen atom, an alkyl group of 1 to 30 carbon atoms which may have a substituent, an alkylamino group of 1 to 30 carbon atoms which may have a substituent, an arylamino group of 6 to 30 carbon atoms which may have a substituent, an alkoxy group of 1 to 30 carbon atoms which may have a substituent, a halogenated alkoxy group of 1 to 30 carbon atoms which may have a substituent, an aromatic oxy group of 6 to 30 carbon atoms whichmayhave a substituent, an aryl group of 6 to 40 carbon atoms which may have a substituent, a heterocyclic group of 3 to 30 carbon atoms whichmay have a substituent, a halogenated alkyl group of 1 to 32 carbon atoms which may have a substituent, an alkenyl group of 2 to 30 carbon atoms which may have a substituent, an alkynyl group of 2 to 30 carbon atoms which may have a substituent, a cycloalkyl group of 3 to 30 carbon atoms which may have a substituent, an electron attractive substituent (aldehyde group, acyl group of 2 to 10 carbon atoms, alkoxycarbonyl group of 2 to 10 carbon atoms, aminocarbonyl group of 1 to 10 carbon atoms, thiocyanate group or sulfonyl group of 1 to 10 carbon atoms), an aralkyl group of 7 to 40 carbon atoms, a silyl group which may be substituted with an alkyl group of 1 to 30 carbon atoms, or a group wherein at least one hydrogen atom in these groups has been replaced with a fluorine atom, and at least one of R₂₀ and R₂₂ is an aryl group which may have a substituent.

As described above, adjacent R groups of R₁ to R₈ do not undergo mutual bonding for forming a ring. The reason is that iridium complex compounds wherein n-conjugation has been extended as a result of the formation of a ring are known to have low emission quantum yields. At least one of R₂₀ and R₂₂ is an aryl group which may have a substituent, as described above. The reason is that when at least one of R₂₀ and R₂₂ is an aryl group which may have a substituent, the emission quantum yield becomes higher as compared with the case where none of them are aryl groups which may have a substituent.

In order to increase a transition dipole moment of a ligand, at least one of R₁ to R₄ in the above formula (1) is an electron attractive substituent. The electron attractive substituent is a fluorine atom, a cyano group, or an alkyl group of 1 to 10 carbon atoms in which at least one hydrogen atom has been replaced with a fluorine atom, and is preferably a fluorine atom, a cyano group or a trifluoromethyl group. It is preferable that at least two of substituents indicated by R₁ to R₄ in the iridium complex compound represented by the formula (1) are each independently selected from a fluorine atom, a cyano group and an alkyl group of 1 to 10 carbon atoms in which at least one hydrogen atom has been replaced with a fluorine atom.

More specifically, it is preferable that R₂ and R₄ are both fluorine atoms, and it is also preferable that R₃ is a trifluoromethyl group.

In order to increase a transition dipole moment of a ligand, R₅ to R₈ are each desirably an electron-donating substituent or an electron-inactive group. More specifically, they are each a hydrogen atom, an alkyl group of 1 to 30 carbon atoms, an aryl group of 6 to 40 carbon atoms, an aralkyl group of 7 to 40 carbon atoms, an amino group which may be substituted with an alkyl group of 1 to 30 carbon atoms, an alkoxy group of 1 to 30 carbon atoms, or a silyl group which may be substituted with an alkyl group of 1 to 30 carbon atoms.

Examples of the alkyl groups of 1 to 30 carbon atoms include methyl group, ethyl group, n-propyl group, isopropyl group, n-butyl group, 2-butyl group, sec- or tert-butyl group, 1-pentyl group, 2-pentyl group, 3-pentyl group, 3-methylbutyl group, 1,1-dimethylpropyl group, n-hexyl group, 2-hexyl group, 3-hexyl group, 4-methylpentyl group, 2-ethylbutyl group, n-heptyl group, 2-heptyl group, 3-heptyl group, 4-heptyl group, n-octyl group, 2-octyl group, 3-octyl group, 4-octyl group, n-ethylhexyl group, n-nonyl group, 2-nonyl group, 3-nonyl group, 4-nonyl group, 5-nonyl group and n-decyl group.

Examples of the aryl groups of 6 to 40 carbon atoms include phenyl group, biphenyl group, terphenyl group, quaterphenyl group, o-, m- or p-tolyl group, xylyl group, o-, m- or p-cumenyl group, mesityl group, pentalenyl group, indenyl group, naphthyl group, binaphthalenyl group, ternaphthalenyl group, quaternaphthalenyl group, azulenyl group, heptalenyl group, biphenylenyl group, indacenyl group, fluoranthenyl group, acenaphthylenyl group, aceanthrylenyl group, phenalenyl group, fluorenyl group, anthryl group, bianthracenyl group, teranthracenyl group, quateranthracenyl group, anthraquinolyl group, phenanthryl group, triphenylenyl group, pyrenyl group, chrysenyl group, naphthacenyl group, preiadenyl group, picenyl group, perylenyl group, pentaphenyl group, pentacenyl group, tetraphenylenyl group, hexaphenyl group, hexacenyl group, rubicenyl group, colonenyl group, trinaphthylenyl group, heptaphenyl group, heptacenyl group, pyranthrenyl group and ovalenyl group.

Examples of the aralkyl groups of 7 to 40 carbon atoms include benzyl, phenethyl, naphthylmethyl and naphthylethyl.

Examples of the amino groups which may be substituted with an alkyl group of 1 to 30 carbon atoms include methylamino group, ethylamino group, dimethylamino group, diethylamino group, dipropylamino group, diisopropylamino group, dibutylamino group, di (sec-butyl) amino group, di(tert-butyl)amino group, dipentylamino group, diisopentylamino group, dineopentylamino group, di(tert-pentyl)amino group, dihexylamino group, diisohexylamino group, diheptylamino group, dioctylamino group, dinonylamino group, didecylamino group, diundecylamino group, didodecylamino group, ditridecyl group, ditetradecylamino group, dipentadecylamino group, dihexadecylamino group, diheptadecylamino group, dioctadecylamino group and dinonadecylamino group.

Examples of the alkoxy groups of 1 to 30 carbon atoms include methoxy group, ethoxy group, propoxy group, isopropoxy group, n-butoxy group, sec-butoxy group, tert-butoxygroup, pentyloxy group, hexyloxy group, 2-ethylhexyloxy group, octyloxy group, octadecyloxy group and stearyloxy group.

Examples of the silyl groups which may be substituted with an alkyl group of 1 to 30 carbon atoms include trimethylsilyl group, triethylsilyl group and tert-butyldimethylsilyl group.

R₁₉ to R₂₇ are each independently a hydrogen atom, a cyano group, a nitro group, a halogen atom, an alkyl group of 1 to 30 carbon atoms which may have a substituent, a halogenated alkyl group of 1 to 32 carbon atoms which may have a substituent, an alkoxy group of 1 to 30 carbon atoms which may have a substituent, a halogenated alkoxy group of 1 to 30 carbon atoms which may have a substituent, an aryl group of 6 to 40 carbon atoms which may have a substituent, a heterocyclic group of 3 to 30 carbon atoms which may have a substituent, an aralkyl group of 7 to 40 carbon atoms, an aromatic oxy group of 6 to 30 carbon atoms which may have a substituent, a cycloalkyl group of 3 to 30 carbon atoms which may have a substituent, an alkenyl group of 2 to 30 carbon atoms which may have a substituent, an alkynyl group of 2 to 30 carbon atoms which may have a substituent, a silyl group which may be substituted with an alkyl group of 1 to 30 carbon atoms, an alkylamino group of 1 to 30 carbon atoms which may have a substituent, an arylamino group of 6 to 30 carbon atoms which may have a substituent, an acyl group of 2 to 10 carbon atoms, an alkoxycarbonyl group of 2 to 10 carbon atoms, an aminocarbonyl group of 1 to 10 carbon atoms, an aldehyde group, a thiocyanate group or a sulfonyl group of 1 to 10 carbon atoms. However, at least one of R₂₀ and R₂₂ is an aryl group which may have a substituent.

As examples of the above substituents, the following groups can be given in addition to the above-mentioned examples.

Examples of the halogenated alkyl groups of 1 to 32 carbon atoms which may have a substituent include trifluoromethyl group and pentafluoroethyl group.

Examples of the halogenated alkoxy groups of 1 to 30 carbon atoms which may have a substituent include trifluoromethoxy group and pentafluoroethoxy group.

Examples of the heterocyclic groups of 3 to 30 carbon atoms which may have a substituent include pyridyl group, pyrazinyl group, thienyl group, phenylthienyl group, thiazolyl group, furyl group, pyranyl group, piperidyl group, piperazyl group, pyrrolyl group, morpholino group, imidazolyl group, pyridazinyl group, oxazolyl group, indolyl group, purinyl group, quinolyl group, isoquinolyl group, pyrimidinyl group, acrydinyl group, coumarinyl group, carbazolyl group and benzothiazolyl group.

Examples of the aromatic oxy groups of 6 to 30 carbon atoms which may have a substituent include phenoxy group, naphthyloxy group and anthryloxy group.

Examples of the cycloalkyl groups of 3 to 30 carbon atoms which may have a substituent include cyclopropenyl group, cyclopentenyl group and cyclohexenyl group.

Examples of the alkenyl groups of 2 to 30 carbon atoms which may have a substituent include alkenylallyl group, 1-propenyl group, isopropenyl group, 2-butenyl group, 1,3-butadienyl group, 2-pentenyl group and 2-hexenyl group.

Examples of the alkynyl groups of 2 to 30 carbon atoms which may have a substituent include ethynyl group and propynyl group.

Examples of the arylamino groups of 6 to 30 carbon atoms which may have a substituent include phenylmethylamino group, methylnaphthylamino group, diphenylamino group and dinaphthylamino group.

Examples of the acyl groups of 2 to 10 carbon atoms include acetyl group, propanoyl group, butanoyl group, benzoyl group, naphthoyl group, pivaloyl group, cyclohexylcarbonyl group, toluoyl group, anisoyl group and cinnamoyl group.

Examples of the alkoxycarbonyl groups of 2 to 10 carbon atoms include methoxycarbonyl group, ethoxycarbonyl group, propyloxycarbonyl group, isopropyloxycarbonyl group, cyclohexyloxycarbonyl group and benzyloxycarbonyl group.

Examples of the aminocarbonyl groups of 1 to 10 carbon atoms include methylaminocarbonyl group and phenylaminocarbonyl group.

Examples of the sulfonyl groups of 1 to 10 carbon atoms include methanesulfonyl group, ethanesulfonyl group and benzenesulfonyl group.

The iridium complex compound represented by the formula (1) is preferably a compound wherein R₆ is an alkyl group of 2 to 30 carbon atoms. When R₆ is an alkyl group of 2 to 30 carbon atoms, solubility of the iridium complex compound tends to be excellent, so that such a compound is preferable. The alkyl group of 2 to 30 carbon atoms is preferably a hydrocarbon group having a branched structure, and examples of such groups include isobutyl group, 2-methylbutyl group, 2-ethylhexyl group, isopropyl group, sec- or tert-butyl group, 1-ethylpropyl group, 1-butylpentyl group, 1,1-dimethylethyl group, 1,1-dimethylpropyl group, 1,1-diethylpropyl group, 1,1-dimethylbutyl group, 1,1-diethylbutyl group, 1,1-dipropylbutyl group, 1,1-dimethylpentyl group, 1,1-diethylpentyl group, 1,1-dipropylpentyl group, 1,1-dibutylpentyl group, 1,1-dimethylhexyl group, 1,1-diethylhexyl group, 1,1-dipropylhexyl group, 1,1-dibutylhexyl group and 1,1-dipentylhexyl group. Of these, tert-butyl group, 1,1-dimethylethyl group, 1,1-dimethylpropyl group, 1,1-dimethylbutyl group, 1,1-dimethylpentyl group and 1,1-dimethylhexyl group are preferable, and tert-butyl group is particularly preferable.

When the number of ligands having a large electric dipole moment is larger, the effect to increase the emission quantum yield becomes higher, so that it is preferable that m is 2 and n is 1.

That is to say, the iridium complex compound represented by the formula (1) is preferably an iridium complex compound represented by the following formula (1-L) or (2-L).

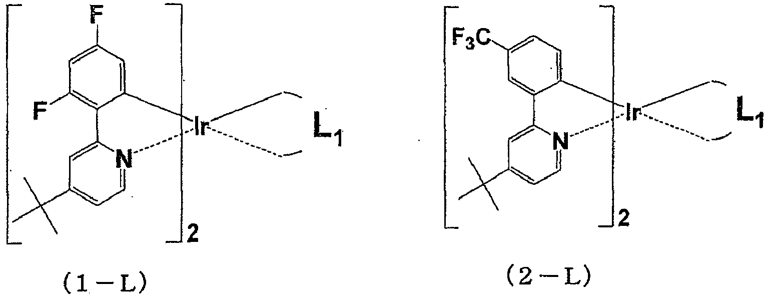

Specific examples of the iridium complex compounds of the present invention are given below. However, the present invention is not limited to those examples.

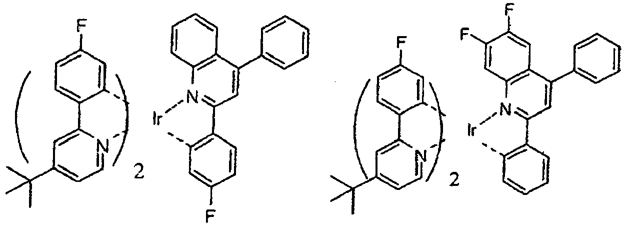

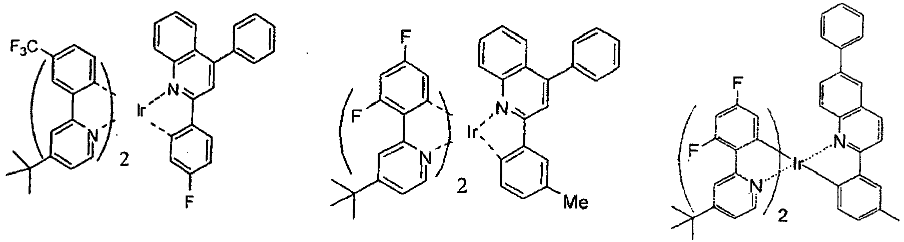

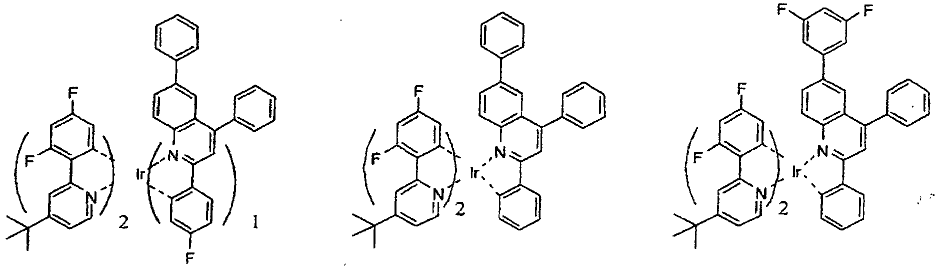

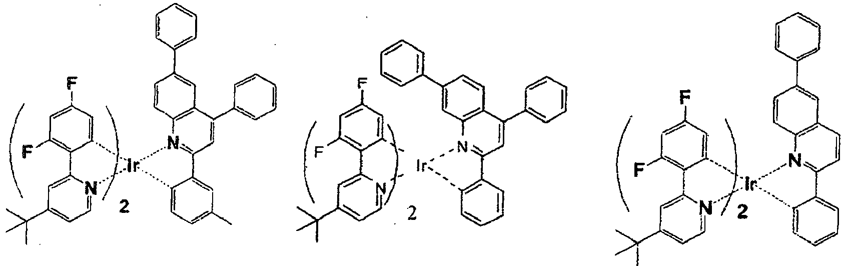

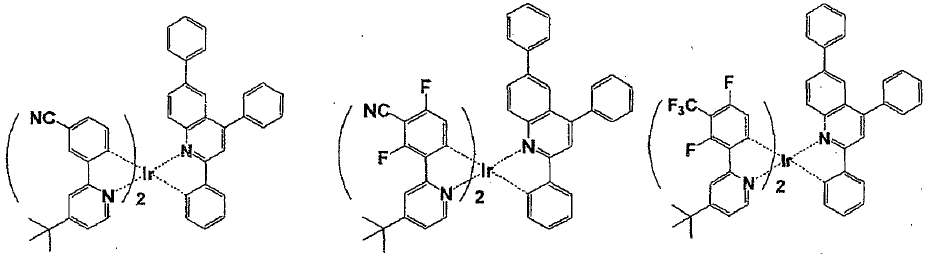

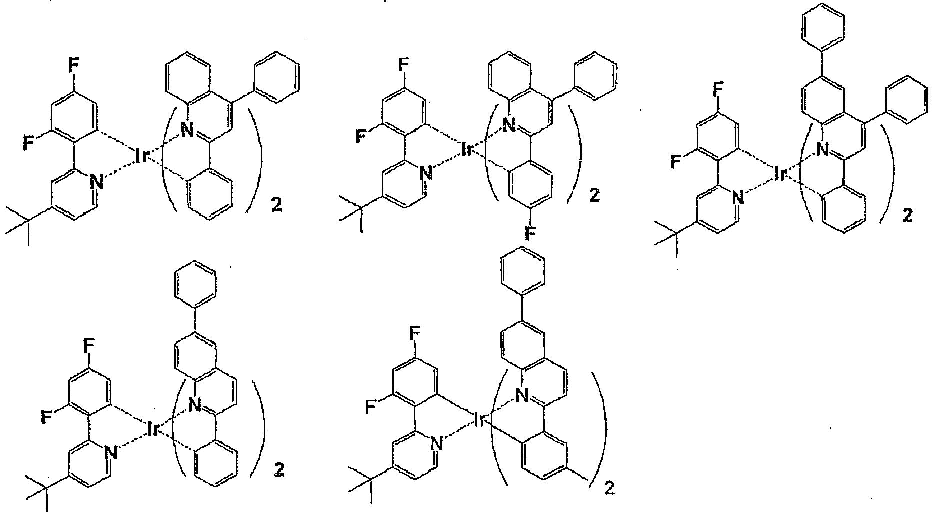

### Preparation process for iridium complex compound

Although the preparation process for the iridium complex compound of the present invention is not specifically restricted, the iridium complex compound can be prepared by, for example, the following process.

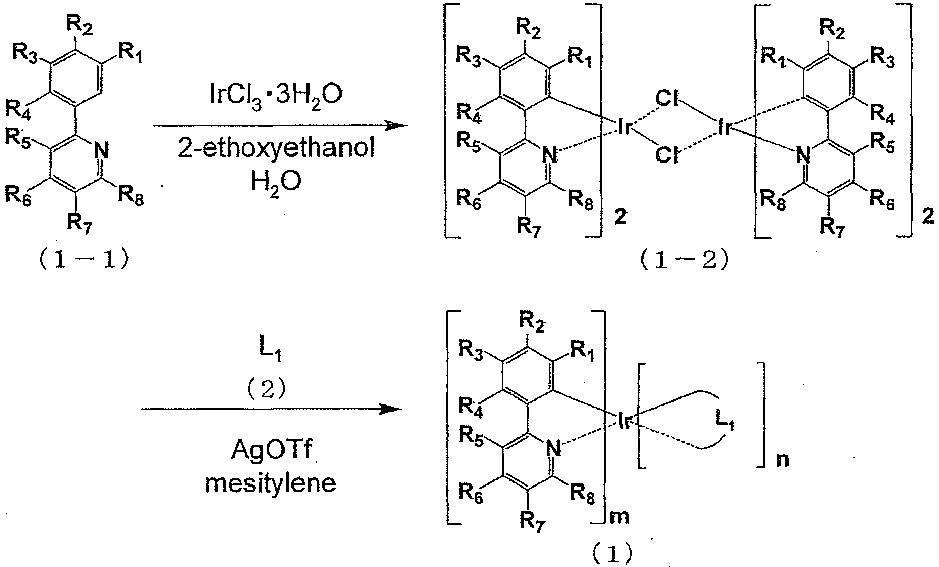

An example of the preparation process for the iridium complex of the present invention is described below referring to the above scheme.

First, iridium(III) chloride trihydrate and a phenylpyridine derivative (1-1) are heated under reflux in a mixed solvent of 2-ethoxyethanol and water (2-ethoxyethanole:water = 3:1 by volume) to react them, whereby a binuclear complex (1-2) of an iridium complex is obtained.

R₁ to R₈ in the formulas (1-1) and (1-2) have the same meanings as those of R₁ to R₈ in the formula (1).

Next, the binuclear complex (1-2) and the ligand of the formula (2) are heated under reflux in a solvent such as toluene in the presence of a silver salt such as silver(I) trifluoromethanesulfonate to react them, whereby the iridium complex compound (1) of the present invention can be obtained. If an inorganic base compound, such as sodium carbonate or potassium carbonate, or an organic base, such as tributylamine or lutidine, is added, the iridium complex compound (1) of the present invention that is a desired product tends to be obtained in a high yield. When toluene is used as the solvent, the iridium complex compound tends to be obtained as a mixture of a facial isomer and a meridional isomer. When heating under reflux is carried out using, as the solvent, a solvent having a higher boiling point, such as mesitylene, an iridium complex compound of a facial isomer tends to be obtained highly selectively and in a high yield.

### Composition

The composition of the present invention is characterized by comprising the above-mentioned iridium complex compound and a blue luminescent compound having a maximum emission wavelength in the wavelength range of 450 to 490 nm.

Since the composition of the present invention comprises the iridium complex compound and a blue luminescent compound having a maximum emission wavelength in the wavelength range of 450 to 490 nm, it can be used as a composition of white luminescence.

The blue luminescent compound is preferably an iridium complex compound represented by the following formula (4).

In the composition of the present invention, the iridium complex compound represented by the following formula (4) is preferably contained in an amount of 1 to 100 parts by weight based on 1 part by weight of the above-mentioned iridium complex compound.

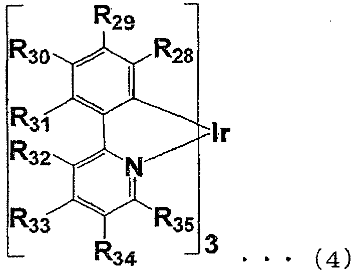

In the formula (4), R₃₂ to R₃₅ are each independently a hydrogen atom, an alkyl group of 1 to 30 carbon atoms, an aryl group of 6 to 40 carbon atoms, an aralkyl group of 7 to 40 carbon atoms, an amino group which may be substituted with an alkyl group of 1 to 30 carbon atoms, an alkoxy group of 1 to 30 carbon atoms, a silyl group which may be substituted with an alkyl group of 1 to 30 carbon atoms, a halogen atom or a cyano group, at least one of R₃₂ to R₃₅ is a group of two or more carbon atoms, R₂₈ to R₃₁ are each independently an electron attractive substituent selected from a halogen atom, an alkyl group of 1 to 10 carbon atoms in which at least one hydrogen atom has been replaced with a fluorine atom, an alkoxy group of 1 to 10 carbon atoms in which at least one hydrogen atom has been replaced with a fluorine atom, a cyano group, an aldehyde group, an acyl group of 2 to 10 carbon atoms, an alkoxycarbonyl group of 2 to 10 carbon atoms, an aminocarbonyl group of 1 to 10 carbon atoms, a thiocyanate group and a sulfonyl group of 1 to 10 carbon atoms, an organic group of 1 to 10 carbon atoms which may have a hetero atom (other than the above-mentioned electron attractive substituent) or a hydrogen atom, and at least one of R₂₈ to R₃₁ is the above-mentioned electron attractive substituent.

As the substituents (aryl group of 6 to 40 carbon atoms, aralkyl group of 7 to 40 carbon atoms, etc.) in the formula (4), the substituents previously given as examples in the aforesaid formula (1) can be used.

### Organic EL element

The organic EL element of the present invention is an organic EL element having a substrate, a pair of electrodes formed on the substrate and one or plural organic layers including a luminescent layer which are provided between the pair of electrodes, wherein the luminescent layer contains the iridium complex compound of the present invention or the composition of the present invention.

The organic EL element is preferably the above-mentioned organic EL element wherein the luminescent layer further contains a charge transport non-conjugated polymer compound.

An example of the structure of the organic EL element of the present invention is shown in Fig. 1, but the structure of the organic EL element of the present invention is not limited thereto. In Fig. 1, between an anode 2 provided on a transparent substrate (e.g., glass substrate) 1 and a cathode 4, a luminescent layer 3 is provided. In the organic EL element, for example, an anode buffer layer may be provided between the anode 2 and the luminescent layer 3, or an electron injection layer may be provided between the luminescent layer 3 and the cathode 4.

When the luminescent layer 3 in the organic EL element is an organic layer containing the iridium compound of the present invention (or the composition of the present invention) and an electron transport non-conjugated polymer compound, this layer can be utilized as a luminescent layer having both of hole transport properties and electron transport properties. On this account, there is an advantage that even if a layer composed of another organicmaterial is not formed, an organic EL element having high luminous efficiency can be produced.

Although the process to produce the organic layer is not specifically restricted, the organic layer can be produced in, for example, the following manner. First, a solution in which the iridium complex compound of the present invention (or the composition of the present invention) and the charge transport non-conjugated polymer compound have been dissolved is prepared. The solvent used for the preparation of the solution is not specifically restricted, but for example, chlorine-based solvents, such as chloroform, methylene chloride and dichloroethane, ether-based solvents, such as tetrahydrofuran and anisole, aromatic hydrocarbon-based solvents, such as toluene and xylene, ketone-based solvents, such as acetone and methyl ethyl ketone, and ester-based solvents, such as ethyl acetate, butyl acetate and ethyl cellosolve acetate, are used. Subsequently, the solution prepared as above is applied onto the substrate using ink jet method, spin coating method, dip coating method, printing method or the like to form a film on the substrate.

The iridium complex compound of the present invention has high solubility in a solvent for a coating solution, and therefore, when the coating solution in which the compound has been dissolved is applied, a uniform film of the compound can be formed on the substrate, so that the iridium complex compound of the present invention is very advantageous.

The concentration of the solution depends upon the compound used, the film-forming conditions, etc., but in the case of, for example, spin coating or dip coating, the concentration is preferably in the range of 0.1 to 10% by weight. Since the iridium complex compound of the present invention has high solubility in solvents as described above, film formation can be easily carried out to realize simplification of the production process, and besides, increase in the area of the element can be achieved.

In the luminescent layer of the organic EL element, the iridium complex compound of the present invention can be used singly or in combination of two or more kinds.

The organic EL element using the iridium complex compound of the present invention in the luminescent layer has a long life and has high luminous efficiency.

### Other materials

For forming the above layers, a polymer material may be mixed as a binder. Examples of the polymer materials include polymethyl methacrylate, polycarbonate, polyester, polysulfone and polyphenylene oxide.

As the materials used for the above layers, materials having different functions, such as a luminescent material, a hole transport material and an electron transport material, may be mixed to form the layers. Also in the organic layer containing the iridium complex compound of the present invention, another hole transport material and/or another electron transport material may be further contained in order to make up for charge transport properties. Such a transport material may be a low-molecular compound or a high-molecular compound.

Examples of the hole transport materials for forming the hole transport layer or the hole transport materials to be contained in the luminescent layer include TPD (N,N'-dimethyl-N,N'-(3-methylphenyl)-1,1'-biphenyl-4,4'-diamine) ; α-NPD (4,4'-bis[N-(1-naphthyl)-N-phenylaminolbiphenyl); low-molecular triphenylamine derivatives, such as m-MTDATA (4,4',4"-tris(3-methylphenylphenylamino)triphenylamine); polyvinylcarbazole; polymer compounds obtained by introducing a polymerizable substituent into the above triphenylamine derivatives and polymerizing them; and fluorescent polymer compounds, such as polyparaphenylenevinylene and polydialkylfluorene. The above polymer compounds are, for example, polymer compounds of a triphenylamine skeleton disclosed in JP-A-H08-157575. The hole transport materials may be used singly or as a mixture of two or more kinds, or different hole transport materials may be used by laminating them. Since the thickness of the hole transport layer depends upon electroconductivity of the hole transport layer, etc., it cannot be defined indiscriminately. However, the thickness thereof is desired to be preferably in the range of 1 nm to 5 µm, more preferably 5 nm to 1 µm, particularly preferably 10 nm to 500 nm.

Examples of the electron transport materials for forming the electron transport layer or the electron transport materials to be contained in the luminescent layer include low-molecular compounds, e.g., quinolinol derivative metal complexes, such as Alq3 (aluminum trisquinolinolate), oxadiazole derivatives, triazole derivatives, imidazole derivatives, triazine derivatives and triarylborane derivatives; and high-molecular compounds obtained by introducing a polymerizable substituent into the above low-molecular compounds and polymerizing them. An example of the high-molecular compound is poly-PBD disclosed in JP-A-H10-1665. The electron transport materials may be used singly or as a mixture of two or more kinds, or different electron transport materials may be used by laminating them. Since the thickness of the electron transport layer depends upon conductivity of the electron transport layer, etc., it cannot be defined in discriminately. However, the thickness thereof is desired to be preferably in the range of 1 nm to 5 µm, more preferably 5 nm to 1 µm, particularly preferably 10 nm to 500 nm.

In order to inhibit passing of holes through the luminescent layer to efficiently recombine holes with electrons in the luminescent layer, a hole block layer may be provided adjacently to the cathode side of the luminescent layer. For forming the hole block layer, publicly known materials, such as triazole derivatives, oxadiazole derivatives, phenanthroline derivatives, pyridine derivatives and phosphine oxide derivatives, are used.

In order to ease injection barrier in the hole injection, a hole injection layer may be provided between the anode and the luminescent layer. For forming the hole injection layer, publicly known materials, such as copper phthalocyanine, a mixture of polyethylene dioxythiophene (PEDOT) and polystyrenesulfonic acid (PSS), and fluorocarbon, are used.

In order to enhance electron injection efficiency, an insulating layer having a thickness of 0.1 to 10 nm may be provided between the cathode and the electron transport layer or between the cathode and an organic layer laminated adjacently to the cathode. For forming the insulating layer, publicly known materials, such as lithium fluoride, magnesium fluoride, magnesium oxide and alumina, are used.

As the anode materials, publicly known transparent conductive materials, e.g., ITO (indium tin oxide), tin oxide, zinc oxide and conductive polymers, such as polythiophene, polypyrrole and polyaniline, are used. The surface resistance of the electrode formed from such a transparent conductive material is preferably in the range of 1 to 50 Ω/□ (ohm/square). The thickness of the anode is preferably in the range of 50 to 300 nm.

As the cathode materials, publicly known cathode materials, e.g., alkali metals, such as Li, Na, K and Cs; alkaline earth metals, such as Mg, Ca and Ba; Al; MgAg alloy; and alloys of Al and alkali metals or alkaline earth metals, such as AlLi and AlCa, are used. The thickness of the cathode is desired to be preferably in the range of 10 nm to 1 µm, more preferably 50 to 500 nm. When a metal of high activity, such as an alkali metal or an alkaline earth metal, is used for the cathode, the thickness of the cathode is desired to be preferably in the range of 0.1 to 100 nm, more preferably 0.5 to 50 nm. In this case, a metal layer that is stable to the atmosphere is laminated on the cathode for the purpose of protecting the cathode metal. Examples of metals for forming the metal layer include Al, Ag, Au, Pt, Cu, Ni and Cr. The thickness of the metal layer is desired to be preferably in the range of 10 nm to 1 µm, more preferably 50 to 500 nm.

As the substrate of the organic EL element of the present invention, an insulating substrate that is transparent to the emission wavelength of the luminescent material is used. In addition to glass, transparent plastics, such as PET (polyethylene terephthalate) and polycarbonate, etc. are used.

Examples of the film-forming methods for the hole transport layer, the luminescent layer and the electron transport layer employable herein include resistance heating deposition method, electron beam deposition method, sputtering method, ink jet method, spin coating method, printing method, spraying method and dispenser method. In the case of the low-molecular compounds, resistance heating deposition or electron beam deposition is preferably used, and in the case of the high-molecular compounds, ink jet method, spin coating method or printing method is preferably used.

Examples of the film-formingmethods for the anode materials employable herein include electron beam deposition method, sputtering method, chemical reaction method and coating method. Examples of the film-forming methods for the cathode materials employable herein include resistance heating deposition method, electron beam deposition method, sputtering method and ion plating method.

### Charge transport non-conjugated polymer compound

The charge transport non-conjugated polymer compound is preferably a polymer obtained by copolymerizing monomers containing at least one polymerizable compound selected from the group consisting of hole transport polymerizable compounds and electron transport polymerizable compounds. In this specification, the hole transport polymerizable compounds and the electron transport polymerizable compounds are also referred to together as "charge transport polymerizable compounds".

That is to say, it is preferable that the charge transport non-conjugated polymer compound is a polymer containing structural units derived from one or more hole transport polymerizable compounds or structural units derived from one or more electron transport polymerizable compounds. When such a polymer is used, mobility of charge in the luminescent layer is high, and a uniform thin film can be formed by coating. Therefore, high luminous efficiency is obtained.

It is more preferable that the charge transport non-conjugated polymer compound comprises a polymer containing structural units derived from one or more hole transport polymerizable compounds and structural units derived from one or more electron transport polymerizable compounds. When such a polymer is used, holes and electrons are more efficiently recombined in the vicinity of the phosphorescent compound because the polymer has both a hole transport function and an electron transport function. Therefore, higher luminous efficiency is obtained.

The hole transport polymerizable compound and the electron transport polymerizable compound are not specifically restricted as far as they have a substituent having a polymerizable functional group, and publicly known charge transport compounds are used.

The polymerizable functional group may be any of radical-polymerizable functional groups, cationic-polymerizable functional groups, anionic-polymerizable functional groups, addition-polymerizable functional groups and condensation-polymerizable functional groups. Of these, a radical-polymerizable functional group is preferable because production of a polymer is easy.

Examples of the polymerizable functional groups include allyl group, alkenyl group, acrylate group, methacrylate group, urethane (meth) acrylate group such as methacryloyloxyethyl carbamate group, vinylamide group and derivatives of these groups. Of these, alkenyl group is preferable.

More specifically, when the polymerizable functional group is an alkenyl group, the substituents having the polymeriable functional group are more preferably substituents represented by the following formulas (A1) to (A12). Of these, the substituents represented by the following formulas (A1), (A5), (A8) and (A12) are still more preferable because the polymerizable functional group can be easily introduced into the charge transport compound.

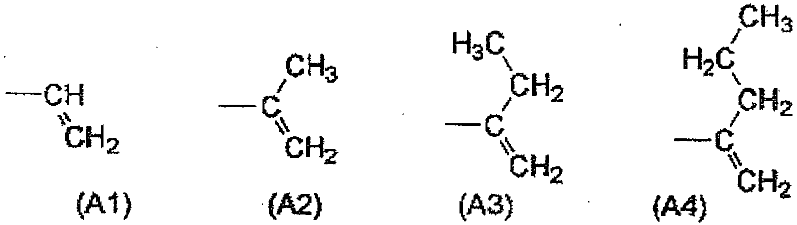

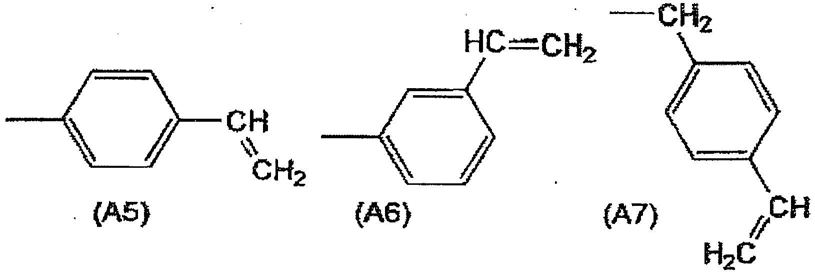

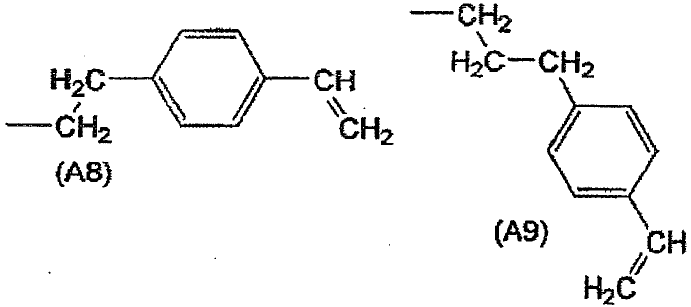

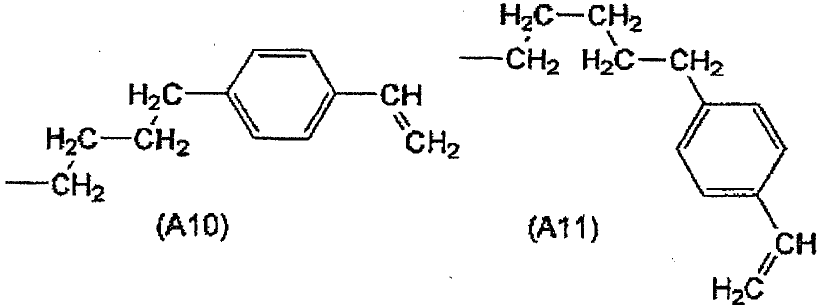

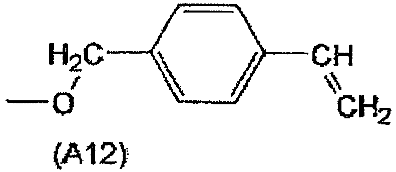

Specifically, the hole transport polymerizable compounds are preferably compounds represented by the following formulas (E1) to (E9). When the iridium complex compound (1) is contained in the luminescent layer, compounds represented by the following formulas (E8) and (E9) are more preferable, and a compound represented by the following formula (E8) is most preferable, from the viewpoint of charge mobility in the non-conj ugatedpolymer compound contained in the luminescent layer. When a composition containing the iridium complex compound is contained in the luminescent layer, compounds represented by the following formulas (E1) and (E2) are more preferable, and a compound represented by the following formula (E2) is most preferable.

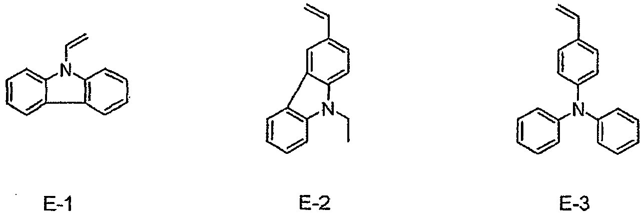

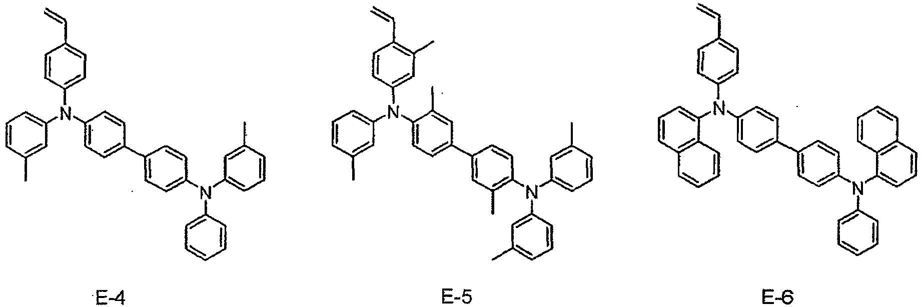

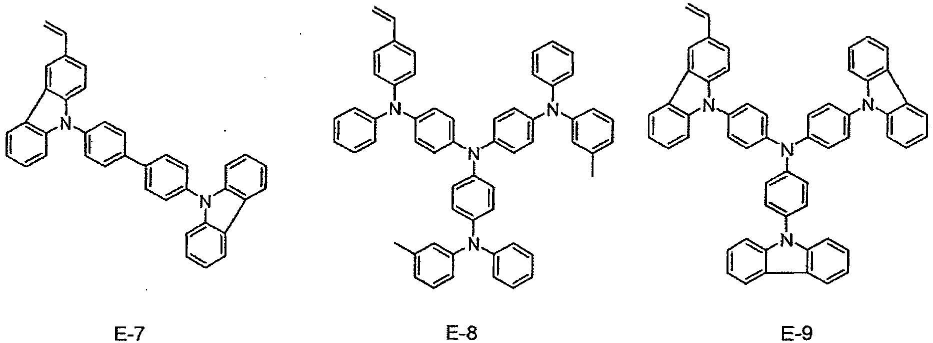

Specifically, the electron transport polymerizable compounds are preferably compounds represented by the following formulas (E10) to (E24). When the iridium complex compound (1) is contained in the luminescent layer, compounds represented by the following formulas (E18) to (E20) are more preferable, and a compound represented by the following formula (E20) ismostpreferable, from the viewpoints of charge mobility in the non-conjugated polymer compound and emission wavelength. When a composition containing the iridium complex compound is contained in the luminescent layer, compounds represented by the following formulas (E15) to (E17) are more preferable, and a compound represented by the following formula (E17) is most preferable.

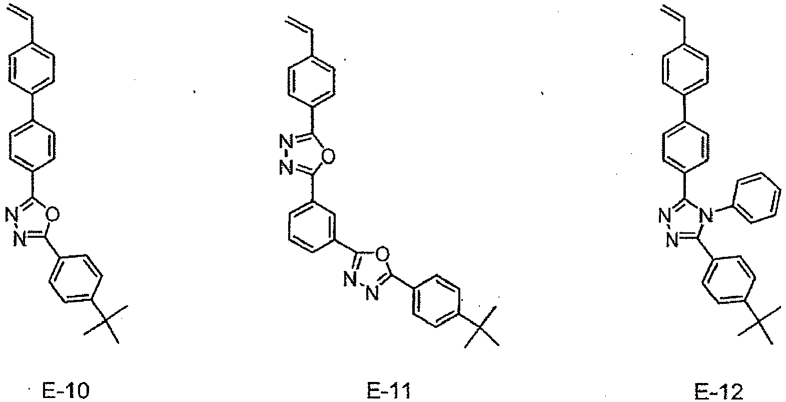

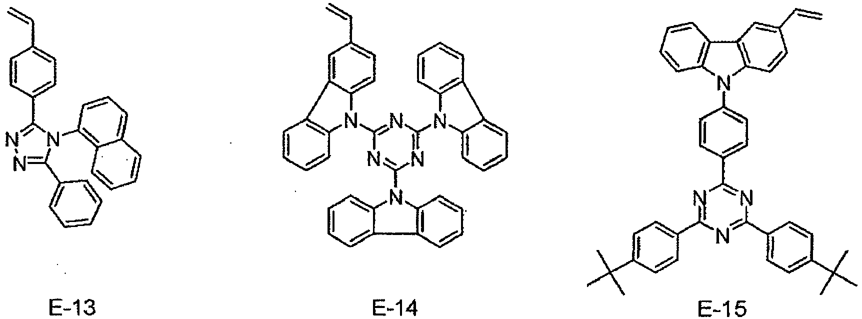

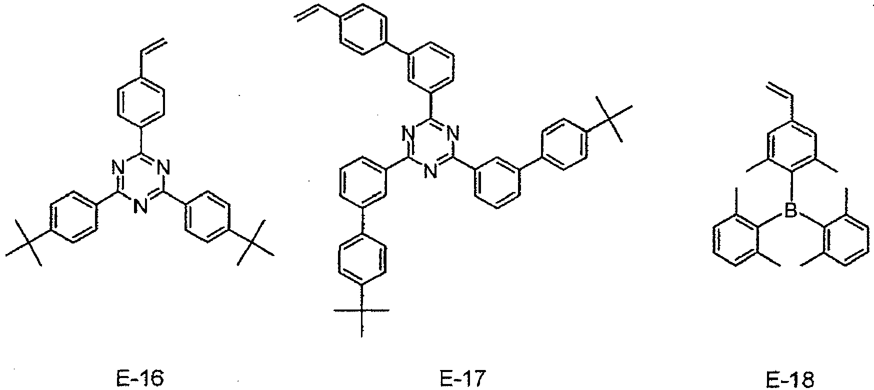

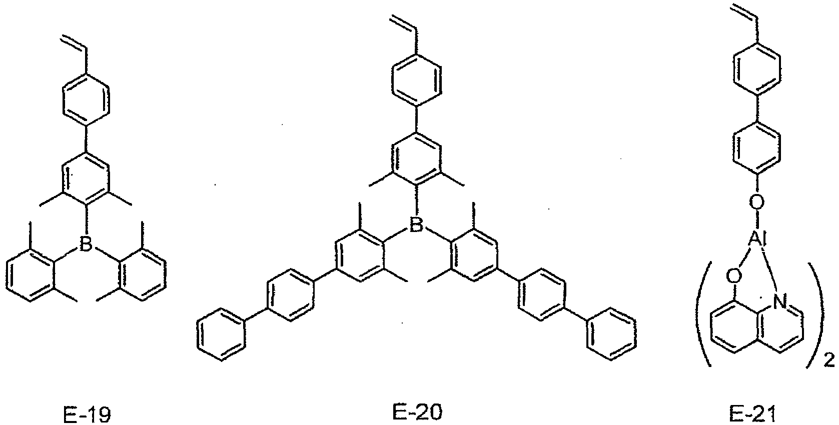

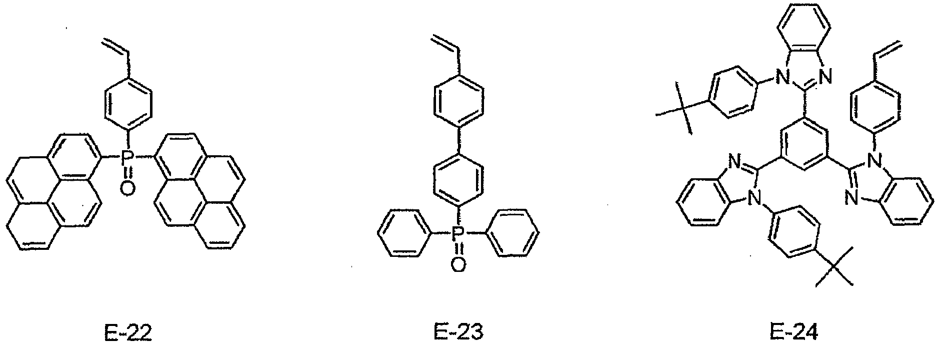

Compounds wherein the substituent represented by the formula (A1) or (A5) in the formulas (E1) to (E24) has been replaced with the substituent represented by any one of the formulas (A2) to (A12) are also preferably used, but a compound having a substituent represented by the formula (A1) or (A5) is particularly preferable because a functional group can be easily introduced into the polymerizable compound.

A compound obtained by copolymerizing a compound represented by any one of the above formulas (E1) and (E2) as the hole transport polymerizable compound and a compound represented by any one of the above formulas (E15) to (E17) as the electron transport polymerizable compound among the above charge transport compounds is more preferable. When such a non-conjugated polymer compound is used, holes and electrons are more efficiently recombined on the phosphorescent compound, and higher luminous efficiency is obtained. Moreover, an organic layer of a homogeneous distribution can be formed from the non-conjugated polymer compound and the phosphorescent compound, and hence, an organic EL element having excellent durability is obtained.

In the organic layer (luminescent layer) which contains the iridium complex compound and the non-conjugated polymer compound and is used in the organic EL element of the present invention, the iridium complex compound is contained in the dispersed state in a matrix formed from the non-conjugated polymer compound. On this account, light emission, utilization of which is usually difficult, that is, light emission from a triplet excitation state of a phosphorescent compound is obtained. Therefore, by the use of the above organic layer, high luminous efficiency is obtained.

The charge transport non-conjugated polymer compound may contain structural units derived from other polymerizable compounds within limits not detrimental to the object of the present invention. Examples of such polymerizable compounds include compounds having no charge transport properties, e.g., (meth)acrylic acid alkyl esters, such as methyl acrylate and methyl methacrylate, styrene and derivatives thereof, without limiting thereto.

The weight-average molecular weight of the charge transport non-conjugated polymer compound is preferably in the range of 1,000 to 2,000,000, more preferably 5,000 to 1,000,000. The molecular weight in this specification means a molecular weight in terms of polystyrene as measured by the use of GPC (gel permeation chromatography) method. When the molecular weight is in this range, the polymer is soluble in organic solvents, and a uniform thin film is obtained, so that such a molecular weight is preferable.

The charge transport non-conjugated polymer compound may be any of a random copolymer, a block copolymer and an alternating copolymer.

The polymerization process to prepare the charge transport non-conjugated polymer compound may be any of radical polymerization, cationic polymerization, anionic polymerization and addition polymerization, but the radical polymerization is preferable.

### Uses

The organic EL element of the present invention is favorably used for an image display device in a publicly known manner as a pixel based on a matrix system or a segment system. The organic EL element is favorably used also as a surface-emitting light source without forming a pixel.

More specifically, the organic EL element of the present invention is favorably used for display devices of computers, televisions, portable terminals, cellular phones, car navigation, view finders of video cameras and the like, back lights, electrophotographs, illumination light sources, recording light sources, exposure light sources, read light sources, markings, signboards, interior goods, optical communication system, etc.

### Examples

Next, the present invention is described in more detail with reference to the following examples, but it should be construed that the present invention is in no way limited to those examples.

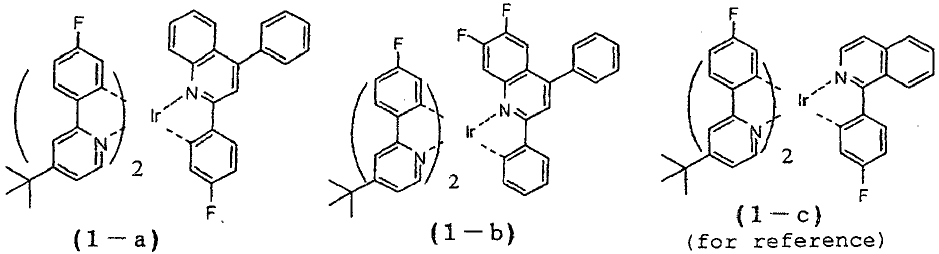

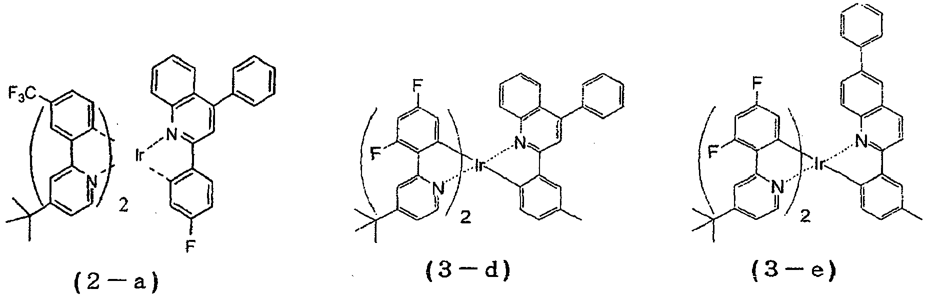

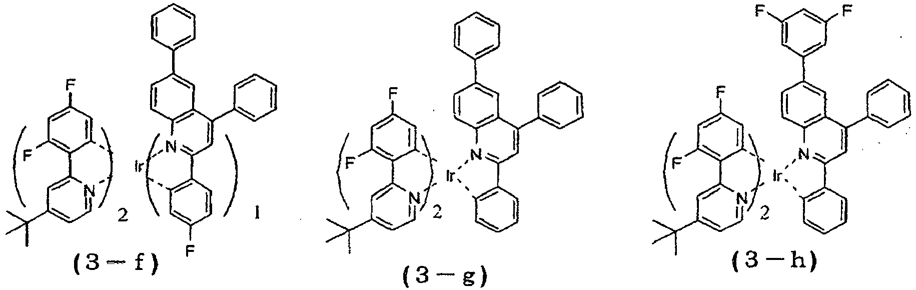

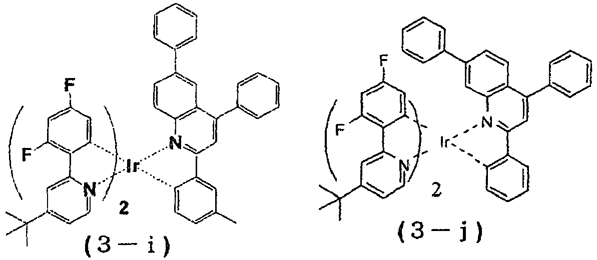

The above iridium complex compounds (1-a) to (3-j) were synthesized in accordance with the following synthesis schemes.

### Example 1

### Synthesis of iridium complex compound (1-a)

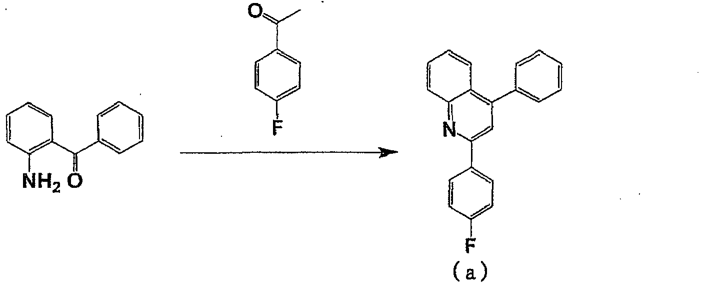

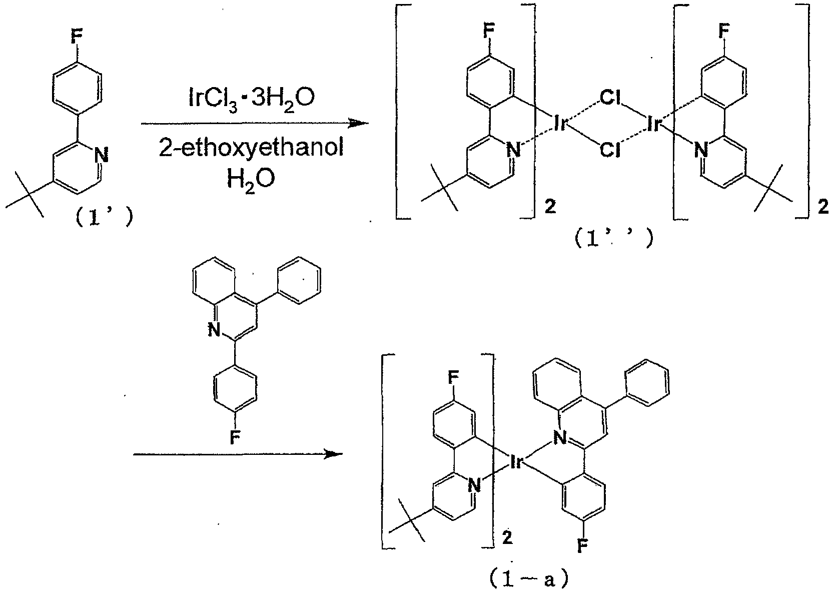

The synthesis is described referring to the above scheme.

### Synthesis of compound (a)

In a 50 ml two-neck flask equipped with a Dimroth condenser and a three-way cock, 1.97 g of 2-aminobenzophenone and 1.38 g of 4-fluoroacetophenone were dissolved in a mixed solvent of 20 ml of acetic acid and 1 ml of sulfuric acid, and the resulting solution was stirred under reflux for 4 hours. Thereafter, 20 ml of ethyl acetate was added, and the mixture was allowed to stand for one night. Since crystals of quinoline sulfate were precipitated, they were filtrated and washed with ethyl acetate. The filter residue was added to 50 ml of methanol to dissolve most of it. To the resulting mixture, 10 ml of 1N-NaOH and 10 ml of water were added. Since white crystals were precipitated, they were filtered and washed with water to obtain a compound (a). The yield was 1.22 g (41%).

### Synthesis of compound (1')

In a 50 ml two-neck flask equipped with a Dimroth condenser and a three-way cock, 371 mg of 2-(4'-fluorophenyl)-4-tert-butyl pyridine having been synthesized in the same manner as in Polyhedron 25, 1167 (2006), 212 mg of iridium(III) chloride trihydrate, 9 ml of 2-ethoxyethanol and 3 ml of pure water were introduced, and through the resulting solution, nitrogen was bubbled for 5 minutes. The resulting solution was refluxed for 14 hours in nitrogen with stirring to perform reaction. After the reaction, the reaction solution was cooled down to room temperature, and 30 ml of pure water was added to precipitate a product. The precipitate was obtained by filtration, washed with 50 ml of a mixed solvent of methanol and water (methanol/water = 7/3) and then dried under reduced pressure to obtain a compound (1') as a yellow powder. The yield was 367 mg (85%).

### Synthesis of compound (1-a)

In a 50 ml two-neck flask equipped with a Dimroth condenser and a three-way cock, 200 mg (0.29 mmol) of the compound (1'), 131 mg (0.36 mmol) of the compound (a) and potassium carbonate (120 mg, 0.87 mmol) were introduced, and the flask was purged with nitrogen. After addition of dehydrated mesitylene (6 ml) and silver(I) trifluoromethanesulfonate (96mg, 0.38 mmol), themixturewas refluxed for 1 hour and 20 minutes with stirring to perform reaction. After the reaction, the reaction solution was cooled down to room temperature, then chloroform was added, and the mixture was filtered using Celite. The filtrate was purified using silica gel column chromatography. Then, methanol was added, and the mixture was ultrasonicated. As a result, crystallization took place. The resulting crystals were filtered and dried to obtain an iridium complex compound (1-a) as red fine crystals. The yield was 38 mg (14%).

### Example 2

### Synthesis of iridium complex compound (1-b)

An iridium complex compound (1-b) was obtained by the same synthesis process as for the iridium complex compound (1-a), except that 2-amino-4,5-difluorobenzophenone was used instead of 2-aminobenzophenone, and 4-acetophenone was used instead of 4-fluoroacetophenone.

### Example 3 (for reference)

### Synthesis of iridium complex compound (1-c)

### Synthesis of compound (c)

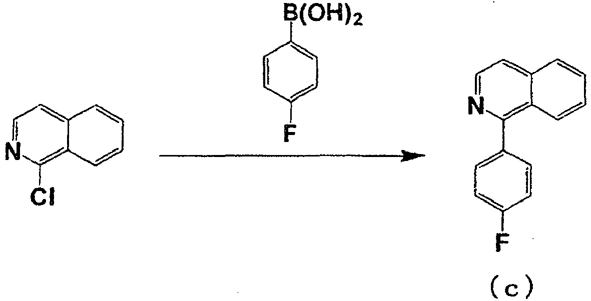

In a mixed solvent of 20 ml of 1,2-dimethoxyethane and 10 ml of water, 1.64 g of 1-chloroisoquinoline, 1.68 g of 4-fluorophenylboric acid, 2.8 g of potassium carbonate and 0.3 g of tetrakis(triphenylphosphine)palladium(0) were dissolved, and the resulting solution was stirred under reflux for 3 hours in a nitrogen atmosphere to perform reaction. After the reaction, the reaction solution was cooled down to room temperature, and 20 ml of toluene was added to remove an aqueous layer. The remainder was purified using silica gel column chromatography to obtain a compound (c). The yield was 2.14 g.

### Synthesis of compound (1-c) (for reference)

An iridium complex compound (1-c) was obtained by the same synthesis process as for the iridium complex compound (1-a), except that the compound (c) was used instead of the compound (a).

### Example 4

### Synthesis of iridium complex compound (2-a)

An iridium complex compound (2-a) was obtained by the same synthesis process as for the iridium complex compound (1-a), except that 2- (3' -trifluoromethylphenyl)-4-tert-butylpyridine having been synthesized in the same manner as in Polyhedron 25, 1167 (2006) was used instead of the compound (1').

### Example 5

### Synthesis of iridium complex compound (3-d)

### Synthesis of compound (d)

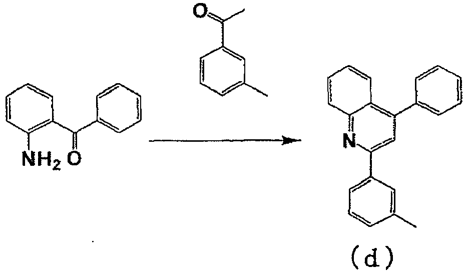

A compound (d) was synthesized in the same manner as for the compound (a), except that 3-methylacetophenone was used instead of 4-fluoroacetophenone.

### Synthesis of compound (3-d)

An iridium complex compound (3-d) was obtained by the same synthesis process as for the iridium complex compound (1-a), except that 2-(2',4'-difluorophenyl)-4-tert-butylpyridine (3') having been synthesized in the same manner as in Polyhedron 25, 1167 (2006) was used instead of the compound (1'), and the compound (d) was used instead of the compound (a).

### Example 6

### Synthesis of iridium complex compound (3-e)

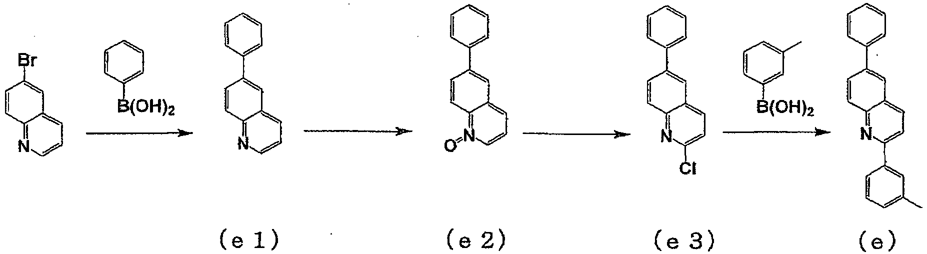

### Synthesis of compound (e1)

In a mixed solvent of 40 ml of 1,2-dimethoxyethane and 20 ml of water, 2.1 g (10 mmol) of 6-bromoaniline, 1.2 g (10 mmol) of phenylboric acid, 2.8 (20 mmol) g of potassium carbonate and 1.1 g (1 mmol) of tetrakis (triphenylphosphine) palladium (0) were dissolved, and the resulting solution was stirred under reflux for 3 hours in a nitrogen atmosphere to perform reaction. After the reaction, the reaction solution was cooled down to room temperature, and 40 ml of toluene was added to remove an aqueous layer. The remainder was purified using silica gel column chromatography to obtain a compound (e1). The yield was 1.64 g (80%).

### Synthesis of compound (e2)

To 1. 64 g (8.0 mmol) of 6-phenylquinoline (compound (e1)), 10 ml of acetic acid and 2 ml of 30% aqueous hydrogen peroxide were added, and they were stirred at 80°C for 3 hours. After the reaction, the reaction solution was washed with a sodium hydroxide aqueous solution. The product was purified by alumina column chromatography to obtain a compound (e2). The yield was 1.70 g (96%).

### Synthesis of compound (e3)

In 5 ml of chloroform, 1.70 g (7.7 mmol) of 6-phenylquinoline-N-oxide (compound (e2)) was dissolved, then 5.9 g (39.5 mmol) of phosphorus oxychloride was slowly added, and the mixture was stirred under reflux for 15 hours in nitrogen. After the reaction, the reaction solution was neutralized with a sodium hydroxide aqueous solution. The resulting solution was purified by silica gel column chromatography to obtain a compound (e3). The yield was 1.1 g (60%).

### Synthesis of compound (e4)

In a mixed solvent of 40 ml of 1,2-dimethoxyethane and 20 ml of water, 1.1 g (4.6 mmol) of 2-chloro-6-phenylquinoline (compound (e3)), 0.63 g (4.6 mmol) of m-methylphenylboric acid, 1. 3 g (9.2 mmol) of potassium carbonate and 0.23 g (0.2 mmol) of tetrakis(triphenylphosphine)palladium(0) were dissolved, and the resulting solution was stirred under reflux for 3 hours in a nitrogen atmosphere to perform reaction. After the reaction, the reaction solution was cooled down to room temperature, and 40 ml of toluene was added to remove an aqueous layer. The remainder was purified using silica gel column chromatography to obtain a compound (e). The yield was 0.65 g (48%).

### Synthesis of compound (3-e)

An iridium complex compound (3-e) was obtained by the same synthesis process as for the iridium complex compound (3-d), except that the compound (e) was used instead of the compound (d).

### Example 7

### Synthesis of iridium complex compound (3-f)

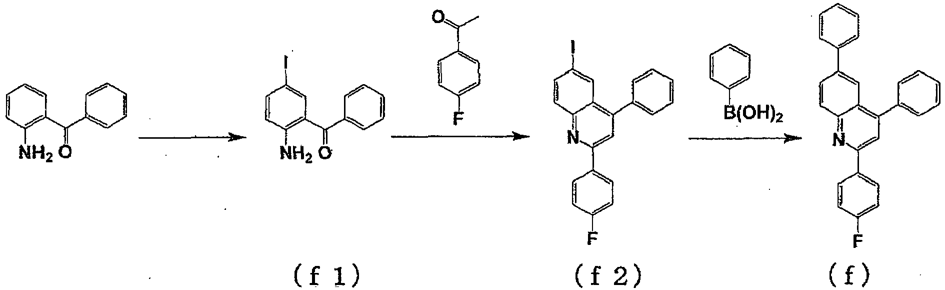

### Synthesis of compound (f1)

In a mixed solvent of 20 ml of methanol and 100 ml of water, 20 ml of 1N-HCl was dropwise added to 4.0 g of aminobenzophenone, 2.2 g of potassium iodide and 1.4 g of iodic acid at room temperature with stirring. After the resulting mixture was allowed to stand for one night, 30 ml of chloroform was added to perform extraction. The extract was washed with a sodium sulfite aqueous solution and then further washed with water twice. The resulting solution was dried over magnesium sulfate and then filtered. The solvent was distilled away under reduced pressure. Then, 30 ml of methanol was added, and the mixture was heated. Thereafter, 3 ml of water was added to precipitate crystals. After filtration, the filter residue was washed with methanol and water to obtain a solid compound (f1). The yield was 4.0% (60%).

### Synthesis of compound (f2)

In 12 ml of acetic acid and 0.6 ml of sulfuric acid, 2.0 g of the compound (f1) and 1.0 g of 4-fluoroacetophenone were dissolved, and the resulting solution was heated and stirred at 120°C for 5 hours. Thereafter, 12 ml of ethyl acetate was added, and the mixture was allowed to stand for one night, then filtered and washed with ethyl acetate. The resulting substance was suspended in 20 ml of methanol, and 12 ml of 1N-NaOH was added to perform neutralization. The product was filtered, and the filter residue was washed with water and methanol to obtain a compound (f2). The yield was 1.7 g (46%).

### Synthesis of compound (f)

In 12 ml of 1,2-dimethoxyethane, 1. 67 g of the compound (f2), 5.58 g of phenylboric acid, 4 ml of a 2M potassium carbonate aqueous solution and 90 mg of tetrakis (triphenylphosphine) palladium (0) were dissolved, and the resulting solution was stirred under reflux for 4 hours in a nitrogen atmosphere to perform reaction. After the reaction, the reaction solution was cooled down to room temperature, and 20 ml of toluene was added to remove an aqueous layer. The remainder was purified using silica gel column chromatography to obtain a compound (f). The yield was 1.03 g (68%).

### Synthesis of compound (3-f)

An iridium complex compound (3-f) was obtained by the same synthesis process as for the iridium complex compound (3-d), except that the compound (f) was used instead of the compound (d).

### Example 8

### Synthesis of iridium complex compound (3-g)

An iridium complex compound (3-g) was obtained by the same synthesis process as in Example 7, except that acetophenone was used instead of 4-fluoroacetophenone.

### Example 9

### Synthesis of iridium complex compound (3-h)

An iridium complex compound (3-h) was obtained by the same synthesis process as in Example 7, except that acetophenone was used instead of 4-fluoroacetophenone, and 3,5-difluorophenylboric acid was used instead of phenylboric acid.

### Example 10

### Synthesis of iridium complex compound (3-i)

An iridium complex compound (3-i) was obtained by the same synthesis process as in Example 7, except that 3-methylacetophenone was used instead of 4-fluoroacetophenone.

### Example 11

### Synthesis of iridium complex compound (3-j)

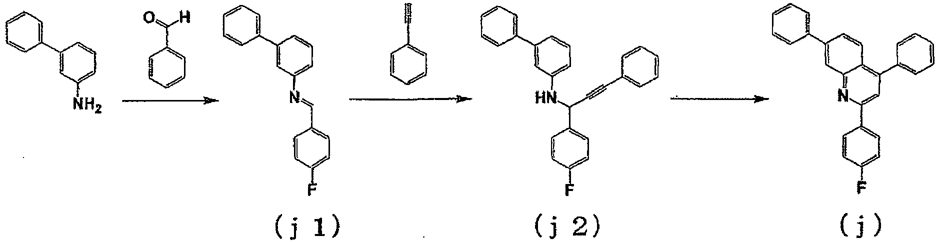

### Synthesis of compounds (j1) and (j2)

2.06 g of 3-aminobiphenyl and 1. 06 g of benzaldehyde were mixed, and the mixture was heated and stirred at 60°C for 1 hour to obtain a compound (j1). To this compound, 80 mg of ruthenium chloride, 0.43 g of copper bromide and 1.2 g of phenylacetylene were added, and they were heated and stirred at 60°C for 2.5 hours. The product was purified by silica gel column chromatography to obtain a compound (j2). The yield was 3.43 g (96%).

### Synthesis of compound (j)

In 30 ml of methanol, 1.0 g of the compound (j2) and 42 mg of gold(III) chloride were dissolved, and the resulting solution was stirred at 50°C for 5 hours. The solvent was distilled away under reduced pressure, and then the remainder was purified by silica gel column chromatography to obtain a compound (j). The yield was 0. 62 g (6%).

### Synthesis of compound (3-j)

An iridium complex compound (3-j) was obtained by the same synthesis process as for the iridium complex compound (3-d), except that the compound (j) was used instead of the compound (d).

### Example 12

### Evaluation of maximum emission wavelength

A maximum emission wavelength of the iridium complex compound (1-a) was obtained by measuring a maximum emission wavelength of a solution obtained by dissolving the iridium complex compound (1-a) in chloroform, by the use of a fluorescence spectrophotometer FP-6500 manufactured by JASCO Corporation. The evaluation result is set forth in Table 1.

### Evaluation of emission quantum yield

An emission quantum yield of the iridium complex compound (1-a) was obtained by measuring an emission quantum yield of a solution obtained by dissolving the iridium complex compound (1-a) in 1,2-dichloroethane, by the use of an absolute emission quantum yield measuring device C9920-02G manufactured by Hamamatsu Photonics K.K. The evaluation result is set forth in Table 1.

### Preparation of organic EL element

Using a glass substrate with ITO (indium tin oxide) film (Nippo Electric Co., Ltd.) in which two ITO electrodes each having a width of 4 mm had been formed in stripes as anodes on one surface of a glass substrate of 25 mm square, an organic EL element was prepared.

The glass substrate with ITO film was ultrasonically cleaned in an alkali detergent for 30 minutes. On the ITO film of the substrate after cleaning, a fluorocarbon film was formed as an anode buffer layer by high-frequency plasma in CHF₃ gas using a reactive ion etching device (Samco RIE-200iP) to obtain a substrate with an anode buffer layer.

Next, 11.8 mg of a copolymer obtained by polymerizing a hole transport material represented by the compound (E8) and an electron transport material represented by the compound (E20) in a ratio of 2:1 (by weight), and 0.4 mg of the iridium complex compound (1-a) were dissolved in 0.4 g of toluene (Wako Pure Chemical Industries, Ltd., special grade). This solution was applied onto the substrate with an anode buffer layer by spin coating under the conditions of a rotational speed of 3000 rpm and a coating time of 30 seconds, and the substrate was allowed to stand at 140°C for 1 hour in a nitrogen atmosphere to form a luminescent layer. The film thickness of the resulting luminescent layer was 86 nm. Next, the substrate having the luminescent layer formed thereon was placed in a deposition device, and lithium fluoride was deposited with a thickness of 5 nm at a deposition rate of 0.01 nm/s. Subsequently, as a cathode, aluminum was deposited with a thickness of 150 nm at a deposition rate of 0.1 nm/s. Thus, an organic EL element 1 was prepared. The layers of sodium fluoride and aluminum were formed in two stripes each having a width of 3 mm and crossing at a right angle to the extending direction of the anode. Thus, four organic EL elements 12 each having a size of 4 mm (length) x 3 mm (width) were prepared based on one glass substrate.

### Evaluation of EL (electroluminescence) properties

A voltage was stepwise applied to the organic EL element using a constant-voltage power source (manufactured by Keithley Instruments Inc., SM2400), and the luminance of the organic EL element was determined by a luminance meter (manufactured by Topcon Corporation, BM-9). Luminous efficiency and power efficiency determined from a ratio of the luminance to a current density are set forth in Table 1.

### Examples 13 to 22 (Example 14 for reference)

Maximum emission wavelengths and emission quantum yields of the iridium complex compounds (1-b) to (3-j) were measured in the same manner as in Example 12, except that the iridium complex compound (1-a) was replaced with each of the iridium complex compounds (1-b) to (3-j) of Examples 2 to 11.

Further, organic EL elements 13 to 22 were prepared in the same manner as for the organic EL element 12 of Example 12, except that the iridium complex compound (1-a) was replaced with each of the iridium complex compounds (1-b) to (3-j) of Examples 2 to 11. These organic EL elements were also subjected to evaluation of electroluminescence properties in the same manner as for the organic EL element 12. The results are set forth in Table 1.

### Comparative Examples 1 to 6

Maximum emission wavelengths and emission quantum yields of the following iridium complex compounds (3-k) to (0-c) were measured in the same manner as in Example 12, except that the iridium complex compound (1-a) was replaced with each of the iridium complex compounds (3-k) to (0-c) below.

Further, organic EL elements c1 to c6 were prepared in the same manner as for the organic EL element 12 of Example 12, except that the iridium complex compound (1-a) was replaced with each of the iridium complex compounds (3-k) to (0-c). These organic EL elements were also subjected to evaluation of electroluminescence properties in the same manner as for the organic EL element 12. The results are set forth in Table 1.

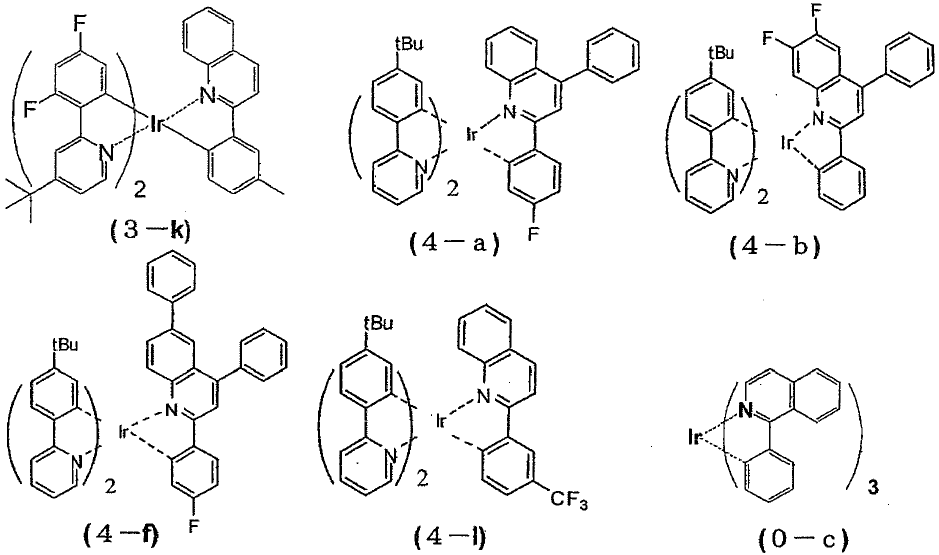

**Table 1**

| | Pigment | Number of electron attractive substituent of phenyl pyridyl ligand | Maximum emission wavelength (nm) | Emission quantum yield (%) | Luminous efficiency (%) | Power efficiency (lm/W) |
|---|---|---|---|---|---|---|
| Ex. 12 | 1-a | 2 | 603 | 0.60 | 9.0 | 13.8 |
| Ex. 13 | 1-b | 2 | 617 | 0.54 | 8.3 | 9.8 |
| Ex. 14 (reference) | 1-c | 2 | 602 | 0.55 | 7.3 | 7.1 |
| Ex. 15 | 2-a | 2 | 603 | 0.71 | 8.2 | 21.4 |
| Ex. 16 | 3-d | 4 | 605 | 0.70 | 9.1 | 19.6 |
| Ex. 17 | 3-e | 4 | 606 | 0.71 | 9.4 | 20.0 |
| Ex. 18 | 3-f | 4 | 600 | 0.75 | 10.0 | 21.8 |
| Ex. 19 | 3-g | 4 | 609 | 0.77 | 10.5 | 20.1 |
| Ex. 20 | 3-h | 4 | 619 | 0.68 | 10.4 | 12.5 |
| Ex. 21 | 3-i | 4 | 610 | 0.74 | 9.3 | 14.9 |
| Ex. 22 | 3-j | 4 | 621 | 0.65 | 9.6 | 19.2 |
| Comp. EX. 1 | 3-k | 4 | 599 | 0.50 | 7.7 | 10.8 |
| Comp. EX. 2 | 4-a | 0 | 620 | 0.40 | 5.8 | 7.4 |
| Comp. EX. 3 | 4-b | 0 | 643 | 0.24 | 3.9 | 2.7 |
| Comp. EX. 4 | 4-f | 0 | 629 | 0.48 | 8.0 | 6.9 |
| Comp. EX. 5 | 4-1 | 0 | 618 | 0.35 | 5.4 | 7.5 |
| Comp. EX. 6 | 0-c | 0 | 620 | 0.26 | 3.5 | 2.1 |

It can be seen from Table 1 that the iridium complexes (Examples 12 to 22) of the present invention using a phenylpyridyl ligand into which an electron attractive substituent had been introduced had high emission quantum yield and the elements prepared using these iridium complexes also had high luminous efficiency and high power efficiency, though the iridium complex compounds (Comparative Examples 2 to 6) using a phenylpyridyl ligand having no electron attractive substituent had low emission quantum yield and the elements prepared using these iridium complex compounds had low luminous efficiency and low power efficiency. It can be also seen that in the case where the iridium complex compounds had 4 fluorine atoms as the electron attractive substituent (Examples 16 to 22), the emission quantum yield, the luminous efficiency and the power efficiency were higher than those in the case where the iridium complex compounds had 2 fluorine atoms as the electron attractive substituent (Examples 12 to 15).

As for the iridium complex compounds of the present invention, when L₁ is a ligand represented by the formula (3), at least one of R₂₀ and R₂₂ is an aryl group which may have a substituent. The iridium complex compounds of the present invention had higher emission quantum yield, higher luminous efficiency and higher power efficiency as compared with the iridium complex compound (3-k) (Comparative Example 1) wherein none of R₂₀ and R₂₂ is aryl groups which may have a substituent.

### Examples 23 to 28

Organic EL elements 23 to 28 were prepared in the same manner as in Example 12, except for using a solution having been prepared by adding 11.8 mg of a copolymer obtained by polymerizing a hole transport material represented by the compound (E8) and an electron transport material represented by the compound (E20) in a ratio of 2:1 (by weight) and 0.4 mg of any one of the iridium complex compounds (1-a) to (3-i) to 0.4 g of toluene (Wako Pure Chemical Industries, Ltd. , special grade) and further adding an iridium complex compound (5-a) in such a concentration that the luminescent chromaticity of the elements would become [0.45, 0.45] in terms of CIE (Commission International de l'Eclairage) chromaticity. These organic EL elements were also subjected to evaluation of electroluminescence properties in the same manner as for the organic EL element 12. The results are set forth in Table 2.

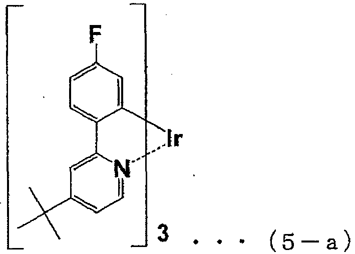

### Comparative Examples 7 and 8

Organic EL elements c7 and c8 were prepared in the same manner as in Examples 23 to 28, except that the iridium complex compounds (4-a) and (4-f) were used instead of the iridium complex compounds (1-a) to (3-i). These organic EL elements were also subjected to evaluation of electroluminescence properties in the same manner as for the organic EL element 12. The results are set forth in Table 2.

**Table 2**

| | Red pigment | Blue pigment | Luminous efficiency (%) | Power efficiency (lm/W) |
|---|---|---|---|---|
| Ex. 23 | 1-a | 5-a | 10.1 | 9.0 |
| Ex. 24 | 2-a | 5-a | 10.9 | 15.0 |
| Ex. 25 | 3-d | 5-a | 11.6 | 14.1 |
| Ex. 26 | 3-f | 5-a | 12.5 | 15.4 |
| Ex. 27 | 3-g | 5-a | 11.3 | 12.7 |
| EX. 28 | 3-i | 5-a | 11.7 | 12.4 |
| Comp. EX. 7 | 4-a | 5-a | 8.6 | 6.5 |
| Comp. EX. 8 | 4-f | 5-a | 8.0 | 4.2 |

It can be seen from Table 2 that the white luminescence organic EL elements (Examples 23 to 28) having been prepared by mixing the red luminescence iridium complex using a phenylpyridyl ligand having an electron attractive substituent with the blue luminescence iridium complex (5-a) had higher luminous efficiency and higher power efficiency than the white luminescence organic EL elements (Comparative Examples 7 and 8) having been prepared by the use of the red luminescence iridium complex using a phenylpyridyl ligand having no electron attractive substituent.

### Examples 29 to 34 (Example 29 for reference)

Organic EL elements 29 to 34 were prepared in the same manner as in Example 12, except for using a solution having been prepared by adding 11.8 mg of a copolymer obtained by polymerizing a hole transport material represented by the compound (E8) and an electron transport material represented by the compound (E20) in a ratio of 2: 1 (by weight) and 0.4 mg of any one of the iridium complex compounds (1-c) to (3-i) to 0.4 g of toluene (Wako Pure Chemical Industries, Ltd., special grade) and further adding an iridium complex compound (5-b) in such a concentration that the luminescent chromaticity of the elements would become [0.40, 0.40] in terms of CIE (Commission International de l'Eclairage) chromaticity. These organic EL elements were also subjected to evaluation of electroluminescence properties in the same manner as for the organic EL element 12. The results are set forth in Table 3.

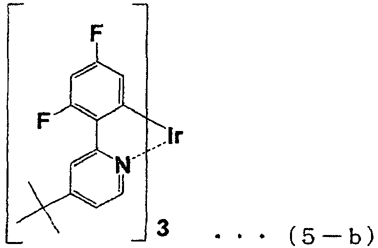

### Comparative Example 9

An organic EL element c9 was prepared in the same manner as in Examples 29 to 34, except that the iridium complex compound (4-b) was used instead of the iridium complex compounds (1-c) to (3-i). This organic EL element was also subjected to evaluation of electroluminescence properties in the same manner as for the organic EL element 12. The results are set forth in Table 3.

**Table 3**

| | Red pigment | Blue pigment | Luminous efficiency (%) | Power efficiency (lm/W) |
|---|---|---|---|---|
| Ex. 29 (reference) | 1-c | 5-b | 7.4 | 6.0 |
| Ex. 30 | 2-a | 5-b | 7.0 | 6.9 |
| Ex. 31 | 3-d | 5-b | 9.4 | 10.4 |
| Ex. 32 | 3-f | 5-b | 8.9 | 9.5 |
| Ex. 33 | 3-g | 5-b | 8.0 | 8.4 |
| EX. 34 | 3-i | 5-b | 8.7 | 8.5 |
| Comp. EX. 9 | 4-b | 5-b | 5.7 | 2.8 |

It can be seen from Table 3 that the white luminescence organic EL elements (Examples 29 to 34) having been prepared by mixing the red luminescence iridium complex compound using a phenylpyridyl ligand having an electron attractive substituent with the blue luminescence iridium complex compound (5-b) had higher luminous efficiency and higher power efficiency than the white luminescence organic EL element (Comparative Example 9) having been prepared by the use of the red luminescence iridium complex using a phenylpyridyl ligand having no electron attractive substituent.

### Reference Signs List

- 1:: substrate
- 2:: anode
- 3:: anode buffer layer
- 4:: luminescent layer
- 5:: cathode

## Claims

1. An iridium complex compound represented by the following formula (1): 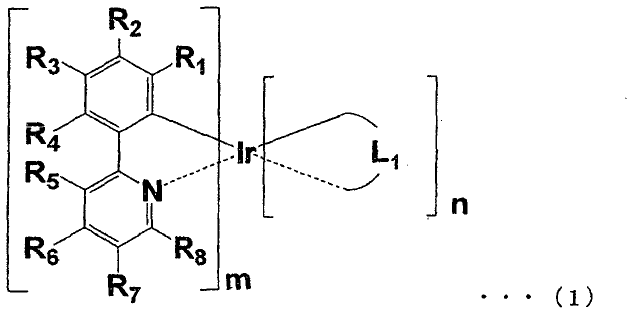 wherein R₁ to R₄ are each independently a hydrogen atom, a fluorine atom, a cyano group, an alkyl group of 1 to 10 carbon atoms, or an alkyl group of 1 to 10 carbon atoms in which at least one hydrogen atom has been replaced with a fluorine atom, at least one of R₁ to R₄ is any one of a fluorine atom, a cyano group and an alkyl group of 1 to 10 carbon atoms in which at least one hydrogen atom has been replaced with a fluorine atom, R₅ to R₈ are each independently a hydrogen atom, an alkyl group of 1 to 30 carbon atoms, an aryl group of 6 to 40 carbon atoms, an aralkyl group of 7 to 40 carbon atoms, an amino group which may be substituted with an alkyl group of 1 to 30 carbon atoms, an alkoxy group of 1 to 30 carbon atoms, or a silyl group which maybe substituted with an alkyl group of 1 to 30 carbon atoms, adjacent R groups of R₁ to R₈ do not undergo mutual bonding for forming a ring, L₁ is the following formula (3), m is 1 or 2, n is 1 or 2, and m+n is 3, 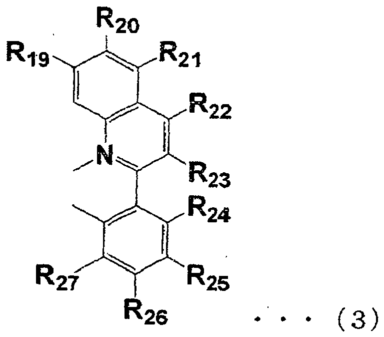 wherein R₁₉ to R₂₇ are each independently a hydrogen atom, a cyano group, a nitro group, a halogen atom, an alkyl group of 1 to 30 carbon atoms which may have a substituent, an alkylamino group of 1 to 30 carbon atoms which may have a substituent, an arylamino group of 6 to 30 carbon atoms which may have a substituent, an alkoxy group of 1 to 30 carbon atoms which may have a substituent, a halogenated alkoxy group of 1 to 30 carbon atoms which may have a substituent, an aromatic oxy group of 6 to 30 carbon atoms which may have a substituent, an aryl group of 6 to 40 carbon atoms which may have a substituent, a heterocyclic group of 3 to 30 carbon atoms which may have a substituent, a halogenated alkyl group of 1 to 32 carbon atoms which may have a substituent, an alkenyl group of 2 to 30 carbon atoms which may have a substituent, an alkynyl group of 2 to 30 carbon atoms which may have a substituent, a cycloalkyl group of 3 to 30 carbon atoms which may have a substituent, an electron attractive substituent (aldehyde group, acyl group of 2 to 10 carbon atoms, alkoxycarbonyl group of 2 to 10 carbon atoms, aminocarbonyl group of 1 to 10 carbon atoms, thiocyanate group or sulfonyl group of 1 to 10 carbon atoms), an aralkyl group of 7 to 40 carbon atoms, a silyl group which may be substituted with an alkyl group of 1 to 30 carbon atoms, or a group wherein at least one hydrogen atom in these groups has been replaced with a fluorine atom, and at least one of R₂₀ and R₂₂ is an aryl group which may have a substituent.

2. The iridium complex compound as claimed in claim 1, wherein at least two of substituents indicated by R₁ to R₄ in the iridium complex compound represented by the formula (1) are each independently selected from a fluorine atom, a cyano group and an alkyl group of 1 to 10 carbon atoms in which at least one hydrogen atom has been replaced with a fluorine atom.

3. The iridium complex compound as claimed in claim 1 or 2, which has a maximum emission wavelength in the range of 580 to 640 nm.

4. A composition comprising the iridium complex compound as claimed in any one of claims 1 to 3 and a blue luminescent compound having a maximum emission wavelength in the wavelength range of 450 to 490 nm.

5. The composition as claimed in claim 4, wherein the blue luminescent compound is an iridium complex compound represented by the following formula (4), and the iridium complex compound represented by the following formula (4) is contained in an amount of 1 to 100 parts by weight based on 1 part by weight of the iridium complex compound as claimed in any one of claims 1 to 3, 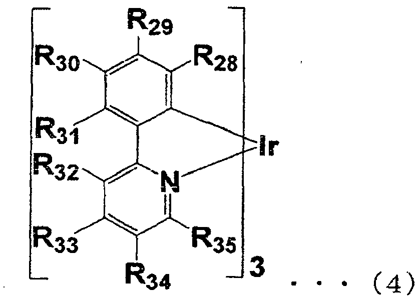 wherein R₃₂ to R₃₅ are each independently a hydrogen atom, an alkyl group of 1 to 30 carbon atoms, an aryl group of 6 to 40 carbon atoms, an aralkyl group of 7 to 40 carbon atoms, an amino group which may be substituted with an alkyl group of 1 to 30 carbon atoms, an alkoxy group of 1 to 30 carbon atoms, a silyl group which may be substituted with an alkyl group of 1 to 30 carbon atoms, a halogen atom or a cyano group, at least one of R₃₂ to R₃₅ is a group of two or more carbon atoms, R₂₈ to R₃₁ are each independently an electron attractive
substituent selected from a halogen atom, an alkyl group of 1 to 10 carbon atoms in which at least one hydrogen atom has been replaced with a fluorine atom, an alkoxy group of 1 to 10 carbon atoms in which at least one hydrogen atom has been replaced with a fluorine atom, a cyano group, an aldehyde group, an acyl group of 2 to 10 carbon atoms, an alkoxycarbonyl group of 2 to 10 carbon atoms, an aminocarbonyl group of 1 to 10 carbon atoms, a thiocyanate group and a sulfonyl group of 1 to 10 carbon atoms, an organic group of 1 to 10 carbon atoms which may have a hetero atom (other than the above-mentioned electron attractive substituent) or a hydrogen atom, and at least one of R₂₈ to R₃₁ is the above-mentioned electron attractive substituent.

6. An organic electroluminescent element having a pair of electrodes and one or plural organic layers including a luminescent layer, wherein the luminescent layer contains the iridium complex compound as claimed in any one of claims 1 to 3 or the composition as claimed in claim 4 or 5.

7. The organic electroluminescent element as claimed in claim 6, wherein the luminescent layer further contains a charge transport non-conjugated polymer.

8. An image display device using the organic electroluminescent element as claimed in claim 6 or 7.

9. A surface-emitting light source using the organic electroluminescent element as claimed in claim 6 or 7.

## Patentansprüche

1. Iridiumkomplexverbindung, dargestellt durch die folgende Formel: 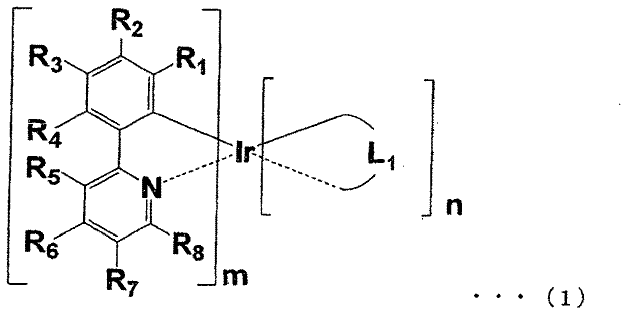 wobei R₁ bis R₄ jeweils unabhängig ein Wasserstoffatom, ein Fluoratom, eine Cyanogruppe, eine Alkylgruppe mit 1 bis 10 Kohlenstoffatomen oder eine Alkylgruppe mit 1 bis 10 Kohlenstoffatomen ist, wobei mindestens ein Wasserstoffatom durch ein Fluoratom ersetzt ist, wobei wenigstens eines von R₁ bis R₄ beliebig ein Fluoratom, eine Cyanogruppe und eine Alkylgruppe mit 1 bis 10 Kohlenstoffatomen ist, wobei mindestens ein Wasserstoffatom durch ein Fluoratom ersetzt ist, wobei R₅ bis R₈ jeweils unabhängig ein Wasserstoffatom, eine Alkylgruppe mit 1 bis 30 Kohlenstoffatomen, eine Arylgruppe mit 6 bis 40 Kohlenstoffatomen, eine Aralkylgruppe mit 7 bis 40 Kohlenstoffatomen, eine Aminogruppe, die mit einer Alkylgruppe mit 1 bis 30 Kohlenstoffatomen substituiert werden kann, eine Alkoxygruppe mit 1 bis 30 Kohlenstoffatomen oder eine Silylgruppe, die mit einer Alkylgruppe mit 1 bis 30 Kohlenstoffatomen substituiert werden kann, ist, wobei benachbarte R-Gruppen von R₁ bis R₈ keine gegenseitige Bindung für die Bildung eines Rings eingehen, wobei L₁ der folgenden Formel (3) entspricht, wobei m 1 oder 2 ist, wobei n 1 oder 2 ist, und wobei m+n gleich 3 ist, 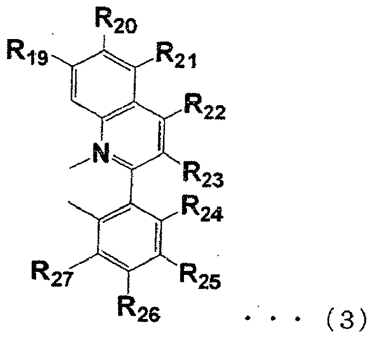 wobei R₁₉ bis R₂₇ jeweils unabhängig ein Wasserstoffatom, eine Cyanogruppe, eine Nitrogruppe, ein Halogenatom, eine Alkylgruppe mit 1 bis 30 Kohlenstoffatomen, die einen Substituenten aufweisen kann, eine Alkylaminogruppe mit 1 bis 30 Kohlenstoffatomen, die einen Substituenten aufweisen kann, eine Arylaminogruppe mit 6 bis 30 Kohlenstoffatomen, die einen Substituenten aufweisen kann, eine Alkoxygruppe mit 1 bis 30 Kohlenstoffatomen, die einen Substituenten aufweisen kann, eine halogenierte Alkoxygruppe mit 1 bis 30 Kohlenstoffatomen, die einen Substituenten aufweisen kann, eine aromatische Oxygruppe mit 6 bis 30 Kohlenstoffatomen, die einen Substituenten aufweisen kann, eine Arylgruppe mit 6 bis 40 Kohlenstoffatomen, die einen Substituenten aufweisen kann, eine heterocyclische Gruppe mit 3 bis 30 Kohlenstoffatomen, die einen Substituenten aufweisen kann, eine halogenierte Alkylgruppe mit 1 bis 32 Kohlenstoffatomen, die einen Substituenten aufweisen kann, eine Alkenylgruppe mit 2 bis 30 Kohlenstoffatomen, die einen Substituenten aufweisen kann, eine Alkynylgruppe mit 2 bis 30 Kohlenstoffatomen, die einen Substituenten aufweisen kann, eine Cycloalkylgruppe mit 3 bis 30 Kohlenstoffatomen, die einen Substituenten aufweisen kann, eine Elektronen anziehende Substituentengruppe (Aldehydgruppe, Acylgruppe mit 2 bis 10 Kohlenstoffatomen, Alkoxycarbonylgruppe mit 2 bis 10 Kohlenstoffatomen, Aminocarbonylgruppe mit 1 bis 10 Kohlenstoffatomen, Thiocyanatgruppe oder Sulfonylgruppe mit 1 bis 10 Kohlenstoffatomen), eine Aralkylgruppe mit 7 bis 40 Kohlenstoffatomen, eine Silylgruppe, die mit einer Alkylgruppe mit 1 bis 30 Kohlenstoffatomen substituiert werden kann, oder eine Gruppe ist, wobei wenigstens ein Wasserstoffatom in diesen Gruppen ersetzt wird durch ein Fluoratom, und wobei wenigstens eines von R₂₀ und R₂₂ eine Arylgruppe ist, die einen Substituenten aufweisen kann.

2. Iridiumkomplexverbindung nach Anspruch 1, wobei wenigstens zwei der Substituenten, die durch R₁ bis R₄ in der durch die Formel (1) dargestellten Iridiumkomplexverbindung angezeigt werden, jeweils unabhängig ausgewählt sind aus einem Fluoratom, einer Cyanogruppe und einer Alkylgruppe mit 1 bis 10 Kohlenstoffatomen, wobei wenigstens ein Wasserstoffatom durch ein Fluoratom ersetzt ist.

3. Iridiumkomplexverbindung nach Anspruch 1 oder 2, die eine maximale Emissionswellenlänge im Bereich von 580 bis 640 nm aufweist.

4. Zusammensetzung, umfassend die Iridiumkomplexverbindung nach einem der Ansprüche 1 bis 3 und eine blau lumineszierende Verbindung mit einer maximalen Emissionswellenlänge im Wellenlängenbereich von 450 bis 490 nm.

5. Zusammensetzung nach Anspruch 4, wobei die blau lumineszierende Verbindung eine durch die folgende Formel (4) dargestellte Iridiumkomplexverbindung ist, und wobei die durch die folgende Formel (4) dargestellte Iridiumkomplexverbindung in einer Menge von 1 bis 100 Gewichtsanteilen auf der Basis von 1 Gewichtsanteil der Iridiumkomplexverbindung nach einem der Ansprüche 1 bis 3 enthalten ist, 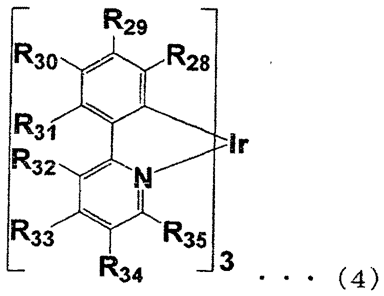 wobei R₃₂ bis R₃₅ jeweils unabhängig ein Wasserstoffatom, eine Alkylgruppe mit 1 bis 30 Kohlenstoffatomen, eine Arylgruppe mit 6 bis 40 Kohlenstoffatomen, eine Aralkylgruppe mit 7 bis 40 Kohlenstoffatomen, eine Aminogruppe , die mit einer Alkylgruppe mit 1 bis 30 Kohlenstoffatomen substituiert sein kann, eine Alkoxygruppe mit 1 bis 30 Kohlenstoffatomen, eine Silylgruppe, die mit einer Alkylgruppe mit 1 bis 30 Kohlenstoffatomen substituiert sein kann, ein Halogenatom oder eine Cyanogruppe ist, wobei wenigstens eines von R₃₂ bis R₃5 eine Gruppe von zwei oder mehr Kohlenstoffatomen ist, wobei R₂₈ bis R₃₁ jeweils unabhängig ein Elektronen anziehender Substituent ist, ausgewählt aus einem Halogenatom, einer Alkylgruppe mit 1 bis 10 Kohlenstoffatomen, wobei mindestens ein Wasserstoffatom durch ein Fluoratom ersetzt ist, einer Alkoxygruppe mit 1 bis 10 Kohlenstoffatomen, wobei mindestens ein Wasserstoffatom durch ein Fluoratom ersetzt ist, einer Cyanogruppe, einer Aldehydgruppe, einer Acylgruppe mit 2 bis 10 Kohlenstoffatomen, einer Alkoxycarbonylgruppe mit 2 bis 10 Kohlenstoffatomen, einer Aminocarbonylgruppe mit 1 bis 10 Kohlenstoffatomen, einer Thiocyanatgruppe und einer Sulfonylgruppe mit 1 bis 10 Kohlenstoffatomen, einer organischen Gruppe mit 1 bis 10 Kohlenstoffatomen, die ein Heteroatom (das sich von dem oben genannten Elektronen anziehenden Substituenten unterscheidet) oder ein Wasserstoffatom aufweisen kann, und wobei wenigstens eines von R₂₈ bis R₃₁ der oben genannte Elektronen anziehende Substituent ist.

6. Organisches, elektrolumineszierendes Element mit einem Elektrodenpaar und einer oder einer Mehrzahl organischer Schichten, einschließlich einer lumineszierenden Schicht, wobei die lumineszierende Schicht eine Iridiumkomplexverbindung nach einem der Ansprüche 1 bis 3 oder die Zusammensetzung nach Anspruch 4 oder 5 aufweist.

7. Organisches, elektrolumineszierendes Element nach Anspruch 6, wobei die lumineszierende Schicht ferner ein nicht konjugiertes Ladungstransport-Polymer enthält.

8. Bildanzeigevorrichtung unter Verwendung des organischen, elektrolumineszierenden Elements nach Anspruch 6 oder 7.

9. Oberflächenemissions-Lichtquelle unter Verwendung des organischen, elektrolumineszierenden Elements nach Anspruch 6 oder 7.

## Revendications

1. Composé complexe d'iridium représenté par la formule (1) suivante : 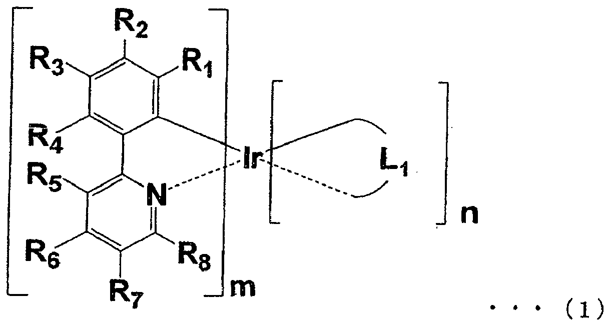 dans laquelle R₁ à R₄ sont indépendamment un atome d'hydrogène, un atome de fluor, un groupe cyano, un groupe alkyle de 1 à 10 atomes de carbone, ou un groupe alkyle de 1 à 10 atomes de carbones dans lequel au moins un atome d'hydrogène a été remplacé par un atome de fluor, au moins un de R₁ à R₄ est n'importe lequel un atome de fluor, un groupe cyano et un groupe alkyle de 1 à 10 atomes de carbone dans lequel au moins un atome d'hydrogène a été remplacé par un atome de fluor, R₅ à R₈ sont indépendamment un atome d'hydrogène, un groupe alkyle de 1 à 30 atomes de carbone, un groupe aryle de 6 à 40 atomes de carbone, un groupe aralkyle de 7 à 40 atomes de carbone, un groupe amino qui peut être substitué par un groupe alkyle de 1 à 30 atomes de carbone, un groupe alcoxy de 1 à 30 atomes de carbone, ou un groupe silyle qui peut être substitué par un groupe alkyle de 1 à 30 atomes de carbone, les groupes R adjacents de R₁ à R₈ ne subissent pas de liaison mutuelle pour former un cycle, L₁ est la formule (3) suivante, m vaut 1 ou 2, n vaut 1 ou 2 et m + n vaut 3, 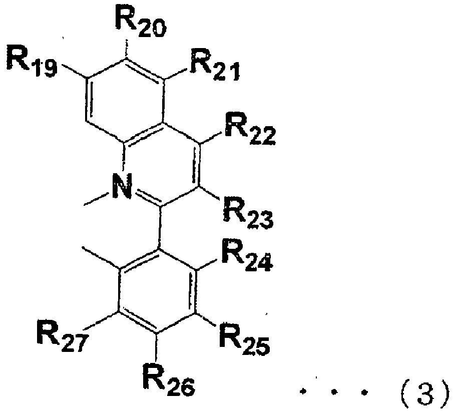 dans laquelle R₁₉ à R₂₇ sont indépendamment un atome d'hydrogène, un groupe cyano, un groupe nitro, un atome d'halogène, un groupe alkyle de 1 à 30 atomes de carbone qui peut avoir un substituant, un groupe alkylamino de 1 à 30 atomes de carbone qui peut avoir un substituant, un groupe arylamino de 6 à 30 atomes de carbone qui peut avoir un substituant, un groupe alcoxy de 1 à 30 atomes de carbone qui peut avoir un substituant, un groupe alcoxy halogéné de 1 à 30 atomes de carbone qui peut avoir un substituant, un groupe oxyle aromatique de 6 à 30 atomes de carbone qui peut avoir un substituant, un groupe aryle de 6 à 40 atomes de carbone qui peut avoir un substituant, un groupe hétérocyclique de 3 à 30 atomes de carbone qui peut avoir un substituant, un groupe alkyle halogéné de 1 à 32 atomes de carbone qui peut avoir un substituant, un groupe alcènyle de 2 à 30 atomes de carbone qui peut avoir un substituant, un groupe alcynyle de 2 à 30 atomes de carbone qui peut avoir un substituant, un groupe cycloalkyle de 3 à 30 atomes de carbone qui peut avoir un substituant, un substituant attracteur d'électrons (groupe aldéhyde un groupe acyle de 2 à 10 atomes de carbone, un groupe acyle de 2 à 10 atomes de carbone, un groupe alcoxycarbonyle de 2 à 10 atomes de carbone, un groupe aminocarbonyle de 1 à 10 atomes de carbone, un groupe thiocyanate ou un groupe sulfonyle de 1 à 10 atomes de carbone), un groupe arylalkyle de 7 à 40 atomes de carbone, un groupe silyle qui peut être substitué par un groupe alkyle de 1 à 30 atomes de carbone, ou un groupe dans lequel au moins un atome d'hydrogène dans ces groupes a été remplacé par un atome de fluor, et au moins un des R₂₀ et R₂₂ est un groupe aryle qui peut avoir un substituant.

2. Composé complexe d'iridium selon la revendication 1, dans lequel au moins deux des substituants indiqués de R₁ à R₄ dans le composé complexe d'iridium représenté par la formule (1) sont chacun indépendamment choisis parmi un atome de fluor, un groupe cyano et un groupe alkyle de 1 à 10 atomes de carbone dans lequel au moins un atome d'hydrogène a été remplacé par un atome de fluor.

3. Composé complexe d'iridium selon la revendication 1 ou la revendication 2, qui possède une longueur d'onde d'émission dans la gamme allant de 580 à 640 nm.

4. Composition comprenant le composé complexe d'iridium selon l'une quelconque des revendications 1 à 3 et un composé luminescent bleu possédant une longueur d'onde d'émission dans la gamme allant de 450 à 490 nm.

5. Composition selon la revendication 4, dans lequel le composé luminescent bleu représenté par la formule (4) suivante, et le composé complexe d'iridium représenté par la formule (4) suivante est contenu dans une quantité de 1 à 100 parties en poids sur la base d'une partie en poids du composé complexe d'iridium selon l'une quelconque des revendications 1 à 3, 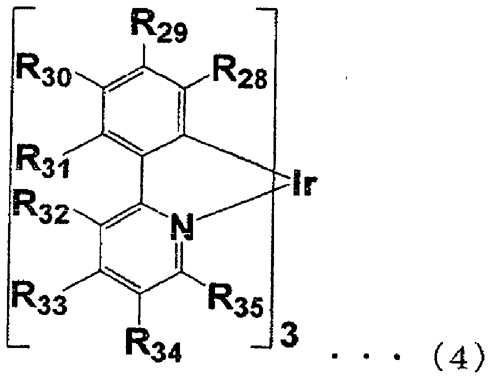 dans laquelle R₃₂ à R₃₅ sont indépendamment un atome d'hydrogène, un groupe alkyle de 1 à 30 atomes de carbone, un groupe aryle de 6 à 40 atomes de carbone, un groupe aralkyle de 7 à 40 atomes de carbone, un groupe amino qui peut être substitué par un groupe alkyle de 1 à 30 atomes, un groupe alcoxy de 1 à 30 atomes, un groupe silyle qui peut être substitué par un groupe alkyle de 1 à 30 atomes, un atome d'halogène ou un groupe cyano, au moins un des R₃₂ à R₃₅ est un groupe constitue de deux ou plusieurs atomes de carbone, R₂₈ à R₃₁ sont indépendamment un substituant attracteur d'électrons choisi parmi un atome d'halogène, un groupe alkyle de 1 à 30 atomes de carbone dans lequel au moins un atome d'hydrogène a été remplacé par un atome de fluor, un groupe cyano, un groupe aldéhyde, un groupe acyle de 2 à 10 atomes de carbone, un groupe alcoxycarbonyle de 2 à 10 atomes de carbone, un groupe aminocarbonyle de 1 à 10 atomes de carbone, un groupe thiocyanate et un groupe sulfonyle de 1 à 10 atomes de carbone, un groupe organique de 1 à 10 atomes de carbone qui peut posséder un hétéroatome (autre que le substituant attracteur d'électrons mentionné ci-dessus) ou un atome d'hydrogène, et au moins un des R₂₈ à R₃₁ est le substituant attracteur d'électrons mentionné ci-dessus.

6. Elément électroluminescent organique possédant une paire d'électrodes et une ou plusieurs couches organiques comprenant une couche luminescente, dans lequel la couche luminescente contient le composé complexe d'iridium selon l'une quelconque des revendications 1 à 3 ou la composition selon la revendication 4 ou la revendication 5.

7. Elément électroluminescent organique selon la revendication 6, dans lequel la couche luminescente contient en outre un polymère non conjugué à transport de charge.

8. Dispositif d'affichage d'images utilisant l'élément électroluminescent organique selon la revendication 6 ou la revendication 7.

9. Source à surface émettant de la lumière utilisant l'élément électroluminescent organique selon la revendication 6 ou la revendication 7.
